Europäisches Patentamt

European Patent Office

Office européen des brevets

(11) Veröffentlichungsnummer: **0 111 741**
**B1**

## (12) EUROPÄISCHE PATENTSCHRIFT

(45) Veröffentlichungstag der Patentschrift:
29.06.88

(51) Int. Cl.⁴: **G 11 C 8/00**

(21) Anmeldenummer: **83111294.1**

(22) Anmeldetag: **11.11.83**

(54) **Integrierte Halbleiterschaltung mit einem dynamischen Schreib-Lese-Speicher.**

(30) Priorität: **24.11.82 DE 3243496**

(43) Veröffentlichungstag der Anmeldung:
**27.06.84 Patentblatt 84/26**

(45) Bekanntmachung des Hinweises auf die Patenterteilung:
**29.06.88 Patentblatt 88/26**

(84) Benannte Vertragsstaaten:
**AT DE FR GB IT**

(56) Entgegenhaltungen:
**EP-A-0 017 228**
**EP-A-0 023 847**
**EP-A-0 033 861**
**US-A-3 969 706**

**IEEE I.S.S.C.C. Februar 18, 1981 Seiten 84-85, NEW YORK (US). EATON et al.: "A 100ns 64K Dynamic RAM using Redundancy Techniques"**
**PATENTS ABSTRACTS OF JAPAN, Band 3, Nr. 54 (E-109) Mai 10, 1979 & JP A 54 32 236 (MITSUBISHI DENKI K.K.) 09-03-1979**

(73) Patentinhaber: **Siemens Aktiengesellschaft Berlin und München, Wittelsbacherplatz 2, D-8000 München 2 (DE)**

(72) Erfinder: **Wawersig, Jürgen, Ing. grad., Plievierpark 10, D-8000 München 83 (DE)**
Erfinder: **Kantz, Dieter, Dipl.- Ing., Heiglhofstrasse 45, D-8000 München 70 (DE)**

## Beschreibung

Gegenstand der vorliegenden Erfindung ist eine integrierte Halbleiterschaltung gemäß dem Oberbegriff des Patentanspruchs 1.

Bekanntlich beginnt bei vielen dynamischen Schreib-Lese-Speichern (also sog. DRAM's) jeder Zyklus mit dem Zeilen-Adreßtakt $\bar{R}\bar{A}\bar{S}$ (=row address strobe), der sämtliche Zeilenadressen über die Adreßleitungen einliest und zwischenspeichert. Dabei wird mindestens eine der vergesehenen Matrixzeilen ausgewählt und die längs dieser Zeile vorgesehenen Speicherzellen durch entsprechende Beaufschlagung der zugehörigen Spaltenleitungen (= Bitleitungen) auf die den einzelnen Spaltenleitungen zugehörenden Leseverstärker geschaltet. Letztere nehmen die in der jeweils adressiertan Speicherzeile eingeschriebene digitale Information auf, die auf diese Weise zwischengespeichert und für den Datenausgang des Speichers zur Verfügung gestellt wird. Mit Beendigung des weiligen Auslesezyklus wird dann die zwischengespeicherte Information von dem betreffenden Leseverstärker wieder an die adressierte Speicherzelle zurückgegeben, wodurch aufgrund des Zeilen-Adreßtaktes $\bar{R}\bar{A}\bar{S}$ ein vom zugehörigen Spalten-Adreßtakt $\bar{C}\bar{A}\bar{S}$ völlig unabhängiges Auffrischen der in der betreffenden Speicherzelle eingeschriebenen Information gegeben ist.

Der zweite Teil eines jeden Zugriffs wird vom Spalten-Adreßtakt $\bar{C}\bar{A}\bar{S}$ (=column address strobe) eingeleitet, der die Spaltenadressen (=Bitleitungsadressen) einliest und abspeichert. Entsprechend dem Zeilen-Adreßtakt $\bar{R}\bar{A}\bar{S}$ wird auch durch den Spalten-Adreßtakt $\bar{C}\bar{A}\bar{S}$ die Dekodierung gesteuert. Er aktiviert den der adressierten Spaltenleitung zugehörigen Leseverstärker, der - wie bereits angedeutet - als Zwischenspeicher wirksam ist, und schaltet den mit der adressierten Speicherzelle verbundenen Anschluß des Zwischenspeichers auf ein Zwischenregister, das gleichzeitig dazu dient, um die Daten nochmals zu verstärken.

Nun ist es bekanntlich (vgl. "1981-IEEE International Solid-State Circuits Conference", S. 84 und 85, bzw. "Elektronik"15/30.7.1982, S. 27 - 30) möglich, einen derartigen DRAM-Speicher so auszugestalten, daß er der eingangs gegebenen Definition entspricht. Da man gewöhnlich solche Speicher in n-Kanal-MOS-Technink herstellt, sind für die Aktivierungsphase die fallenden Flanken der steuernden Taktimpulse verantwortlich. Der in der oben angegebenen Definition aufgeführte Betriebsmodus, bei dem nicht nur der Inhalt einer Einzelzelle sondern infolge der entsprechenden Ausbildung der Adressierung auch der Dateninhalt wenigstens einer weiteren Speicherzelle an den Datenausgang geliefert werden kann, wird als "Nibble-Mode" bezeichnet, wenn jeweils vier Bits seriel zur Verfügung gestellt werden. Daneben besteht noch der "BYTE-Betrieb", bei dem bei jeder Adressierung ein aus acht Bits bestehendes Datenwort zur Verfügung gestellt wird. Im einfachsten Fall handelt es sich um den "Dual-Mode", bei dem bei jeder Adressierung zwei Bits geliefert werden. Die im Zwischenregister gespeicherten Daten werden unter Verwendung des genannten Schieberegisters am Datenausgang des Speichers seriell zur Verfügung gestellt.

Der Nibble-Mode wird bei den diesbezüglich ausgestalteten DRAM-Speichern dadurch aktiviert, daß der Zeilen-Adresstakt $\bar{R}\bar{A}\bar{S}$ auf Low liegt und der Spalten-Adreßtakt $\bar{C}\bar{A}\bar{S}$ auf High geschaltet wird, wodurch der Detenausgang gesperrt und der Spalten-Adreßtakt $\bar{C}\bar{A}\bar{S}$ anschlieBend wieder auf Low gelegt wird. Hierdurch wird dann das nächste Datenbit angefordert. Diese Operation kann bei bekannten Speichertypen alle 55 nsec bzw. 65 nsec wiederholt werden, so daß mit einer maximalen Datenrate von 14...16 MHz bei geeignet ausgelegter Ansteuerschaltung gerechnet werden kann. Durch das Takten der Spannung am $\bar{C}\bar{A}\bar{S}$-Anschluß wird der Zugriff auf vier aufeinanderfolgende Bits beim Nibble-Mode-Betrieb möglich. Dann kann der Zeilen-Adreßtakt $\bar{R}\bar{A}\bar{S}$ auf High geschaltet werden, um einen neuen Zugriffszyklus zu beginnen. Durch erneutes Anlegen der Zeilen- und Spaltenadressen werden erneut vier Zellen ausgelesen. Dadurch bleibt auch der wahlfreie Datenzugriff möglich. Als wesentlicher Vorteil des Betriebs im Nibble-Mode ist ein schnelleres Auslesen im Vergleich zum bisher üblichen seriellen Betrieb, d.h. dem Page-Mode-Betrieb, zu verzeichnen.

Nun können bei DRAM's, die mit dem Nibble- oder mit dem Byte-Modus arbeiten, die gespeicherten Daten allein mit dem Takt $\bar{C}\bar{A}\bar{S}$ seriell in kurzer Zyklusfolge ausgelesen werden, wie soeben festgestellt wurde. Da aber die minimale $\bar{C}\bar{A}\bar{S}$-LOW-Zeit, also die Zeitspanne $t_{NAS}$ (= CAS-LOW-Zeit im Nibble-Mode) gleich der maximalen Zugriffszeit $t_{NAC}$ ist, reicht die bisher am Datenausgang vorgesehene Speicherzeit $t_{OFF}$ für eine Datenbewertung nicht aus, wie aufgrund der zu der vorliegenden Erfindung führenden Untersuchungen festgestellt wurde. Dabei ist noch festzustellen, daß diese Speicherzeit $t_{OFF}$ bei den bekannten Speichern der für den Nibble-Mode geeigneten Art nicht in einem endlichen minimalen Wert sondern meistens mit $t_{OFFmin}$ = Null nsec spezialisiert ist. Aus diesen Gründen kann im allgemeinen bei den bekannten Speichern entsprechend der eingangs gegebenen Definition die minimale Zykluszeit $t_{NC-min}$ nicht ausgenutzt werden.

Aus der US-PS-3 969 706 ist eine Halbleiterspeicherschaltung mit Adreß-Multiplex-Betrieb bekannt, die sowohl in einem sogenannten "Normal-Mode"-Betrieb (d.h. innerhalb eines einzigen Betriebstaktes wird genau eine einzige Speicherzelle adressiert) als auch im sogenannten "Page-Mode"-Betrieb adressierbar ist. Unter "Page-Mode"-Betrieb wird dabei verstanden, daß innerhalb eines einzigen sogenannten "$\overline{\text{RAS}}$-Zyklus' (d.h. während eine einzige beliebig wählbare Zeile von Speicherzellen angewählt ist), durch einfaches Takten eines sogenannten "$\overline{\text{CAS}}$"-Signales unter Anlegen verschiedener Spaltenadressen (je Spaltenadresse ein $\overline{\text{CAS}}$-Takt) beliebig viele Speicherzellen der angewählten Zeile von Speicherzellen anwählbar sind. Die Halbleiterspeicherschaltung enthält Schaltungsteile, die es ermöglichen, das am Datenausgang anliegende Datenausgangssignal solange gültig zu halten, bis der nächste ($\overline{\text{CAS}}$-)Zyklus begonnen hat. Dies ist unabhängig von der Betriebsart, mit der die Halbleiterspeicherschaltung gerade betrieben wird (Normal-Mode oder Page-Mode).

Aufgabe der vorliegenden Erfindung ist es, bei integrierten Halbleiterschaltungen der gattungsgemäßen Art, die ja unter anderem die Möglichkeit des Byte- bzw. Nibble-Mode-Betriebes bieten, die Gültigkeit des Datenausgangssignales, d.h. also, die vorgenannte Zeit $t_{NOFF}$ geeignet zu verlängern, ohne dabei den Betrieb im Normalmodus zu beeinflussen.

Aus den soeben dargelegten Gründen ist gemäß der Erfindung bei einer der eingangsgegebenen Definition entsprechenden integrierten Halbleiterschaltung mit einem dynamischen Schreib-Lese-Speicher die Steuerung des Datenausgangs über den Spalten-Adreßtakt $\overline{\text{CAS}}$ derart ausgebildet, daß die jeweils am Datenausgang anhängige und durch das Schieberegister zur Verfügung gestellte Information nach dem Abklingen des ihre Auslesung veranlassenden Spalten-Adreßtaktsignals $\overline{\text{CAS}}$ noch eine - ggf. bis zum Einsetzen des nächsten Spalten-Adreßtaktsignals $\overline{\text{CAS}}$ reichende - definierte Zeitspanne am Datenausgang des Speichers erhalten bleibt. Ebenso ist gemäß der vorliegenden Erfindung vorgesehen, daß die so erzielbare Verlängerung der Verfügbarkeit der Dateninformation am Datenausgang gesteuert über den Zeilen-Adreßtakt, in einer zweiten Betriebsart der Halbleiterschaltung wirksam ist, bei der beim Übergang des Spalten-Adreßtaktes in den HIGH-Zustand sich gleichzeitig der Zeilen-Adreßtakt auf LOW-Pegel befindet.

Dies erlaubt, bei geeigneter Spezifikation eines Minimalwertes $t_{NOFFmin}$ fur diese Verfügbarkeit bei den obengenannten Spezialmodi, trotz minimaler Zeitspanne $t_{NAS}$, die effektive minimale Zykluszeit $t_{NC}$ gegenüber den gattungsgemäßen integrierten Halbleiterschaltungen im Nibble-Mode weiter zu reduzieren, ohne dabei die Verfügbarkeit der Dateninformationen im Normal-Mode unzulässigerweise zu erhöhen.

Die Erfindung wird nun anhand der Figuren näher beschrieben. Dabei beziehen sich die Fig. 1 und 2 auf eine gattungsgemäße Halbleiterschaltung. Die Fig. 3, 3a, 3b und 3c dienen, obwohl nicht Bestandteil der Erfindung, samt ihrer zugehörigen Erläuterung dem besseren Verständnis der ab Fig. 4 dargestellten Erfindung.

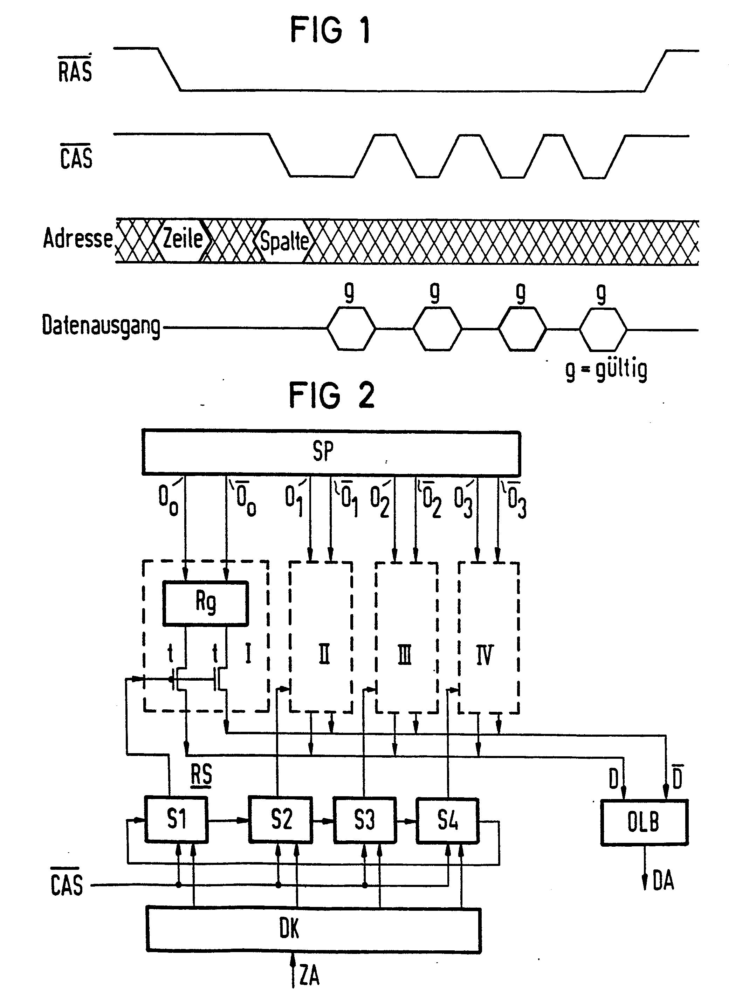

In Figur 1 ist das beim Nibble-Mode übliche Zeitdiagramm und in Figur 2 das verein achte Blockschaltbild für den hierfür üblichen DRAM-Speicher gezeigt.

Dabei ist im Hinblick auf das bei den üblichen Ausgestaltungen von DRAM's mit Nibble- und Byte-Mode gültige Zeitdiagramm gemäß Figur 1 festzustellen, daß eine Adresse angelegt und durch viermaliges Takten der $\overline{\text{CAS}}$-Leitung (also durch vier nach dem Auftreten des $\overline{\text{RAS}}$-Impulses sukzessive erzeugte $\overline{\text{CAS}}$-Impulse) der Datenausgang viermal geöffnet wird, was durch die Zeitbereiche "g" (= gültig) angedeutet ist. Bei der hierzu bekannten Schaltungsstruktur gemäß Figur 2 ist festzustellen, daß zu deren Beaufschlagung 4 Paare von Datenleitungen $O_0$, $\bar{O}_0$, $O_1$, $\bar{O}_1$,...$O_3$, $\bar{O}_3$ des eigentlichen Zellenfelds, also der Speichermatrix SP, vorgesehen sind. Diese werden durch die Spalten-Adreßdekoder mit 4 Bitleitungen verbunden.

Je zwei zusammengehörende Datenausgänge $O_x$, $\bar{O}_x$ der Speichermatrix SP dienen der Beaufschlagung je eines von vier Schaltungsteilen I, II, III und IV, die einander gleich sind, so daß in der Zeichnung lediglich bei einem dieser Schaltungsteile, nämlich beim Schaltungsteil I, die für den Nibble-Mode wesentlichen Bestandteile angedeutet sind. Diese bestehen aus einem Zwischenregister Rg mit zwei Signaleingängen, die durch jeweils zwei zusammengehörende (also stets zueinander invertierte Signale führende) Ausgänge $O_x$, $\bar{O}_x$ gesteuert sind. Außerdem ist aufgrund des in dem Zwischenregister Rg des betreffenden Schaltungsteils festgehaltenen Datenzuständes die Beaufschlagung des einen stromführenden Anschlusses je eines n-Kanal-MOS-Feldeffekttransistors t gegeben, dessen zweiter stromführender Anschluß an je einen der beiden Eingänge D und $\bar{D}$ der gemeinsamen Ausgangstreiberstufe OLB gelegt ist. Dabei ist der eine Eingang D mit den aufgrund der Adressierung erhaltenen und tatsächlich in den adressierten Zellen gespeicherten Daten und der andere Eingang $\bar{D}$ mit den hierzu invertierten Daten beaufschlagt. (Die Daten D entsprechen den von den Ausgängen $O_0$, $O_1$, $O_2$ und $O_3$ der Speichermatrix SP gelieferten Daten, während die Daten $\bar{D}$ von den hierzu invertierten Ausgängen $\bar{O}_0$, $\bar{O}_1$, $\bar{O}_2$ und $\bar{O}_3$ der Speichermatrix SP stammen.)

Wesentlich ist ein Vier-Bit-Ringschieberegister RS mit den Stufen S1, S2, S3 und S4, das durch den Spalten-Adreßtakt $\overline{\text{CAS}}$ getaktet wird und dessen einzelne Stufen S1 bis S4 über einen durch eine Zusatzadresse ZA gesteuerten 1 : 4 Dekoder DK mit Steuerungsdaten versehen werden. Der datenführende Ausgang der einzelnen Registerstufen S1 - S4 dient zur Steuerung der Gates des in jeweils einem der genannten Schaltungsteile I - IV jeweils vorgesehenen Transistorpaares t und damit zur Steuerung des Datenflusses zu dem Ausgangstreiber OLB. Letzterer enthält außer der Treiberfunktion noch die Funktion der Pegelanpassung, z. B. für den Betrieb einer TTL-Logik. Der Datenausgang DA ist durch den Ausgang des Schaltungsteils OLB gegeben.

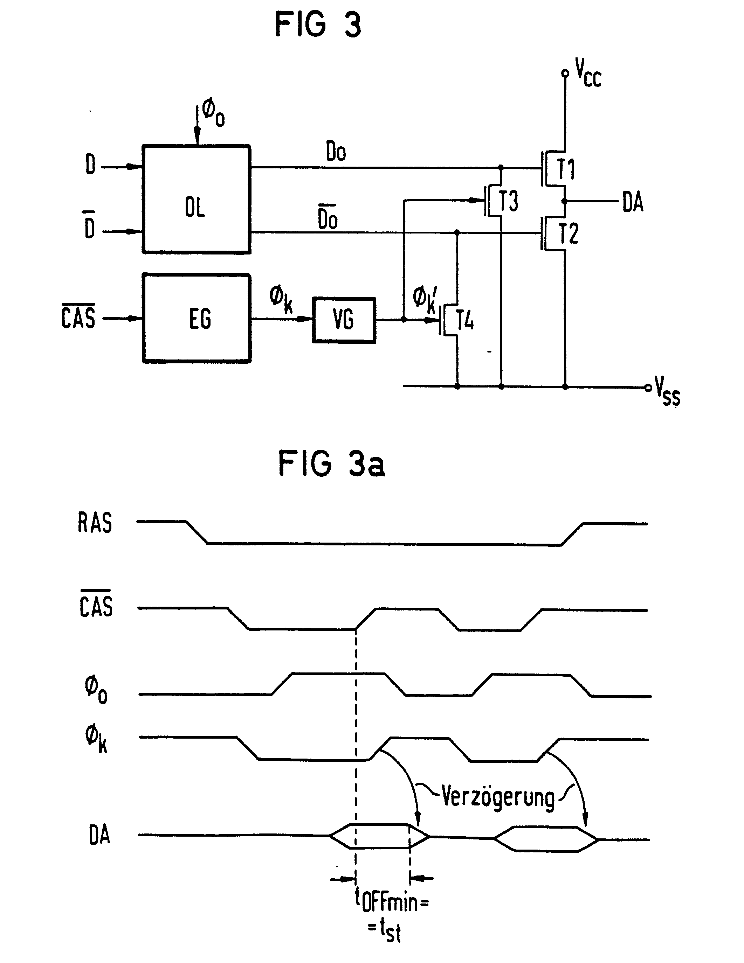

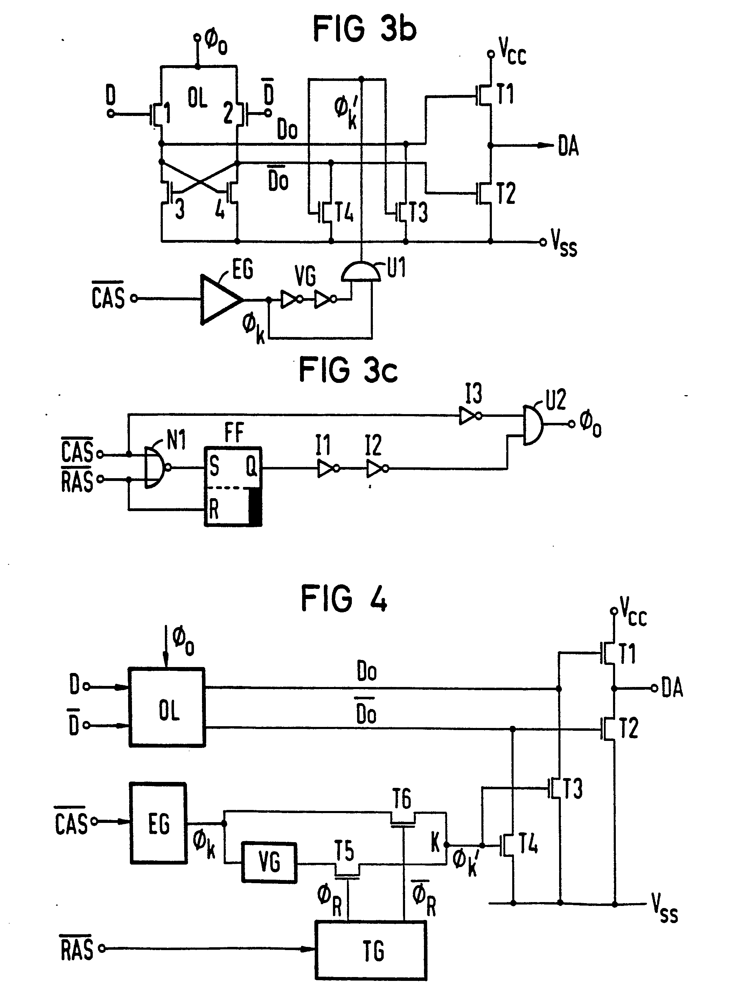

Das Ziel der Erfindung ist es nun, die bekannte Speicherschaltung so zu verbessern, daß trotz des aus Figur 1 ersichtlichen Schaltens des Spalten - Adreßtakts $\overline{CAS}$ auf Pegel HIGH wenigstens bei bestimmten Betriebsarten des Speichers die aus Figur 1 ersichtlichen Zeitabstände g (=gültig) am Datenausgang DA für eine begrenzte, definierte Zeitspanne erhalten bleiben. Hierzu ist es zweckmäßig, von der bekannten Ausgestaltung des Ausgangstreibers OLB auszugehen und diese durch Weitere Schaltungsteile zu ergänzen, die die beabsichtigte Wirkung sicherstellen. Eine mögliche diesbezügliche Ausgestaltung wird anhand der Figuren 3, 3a, 3b und 3c beschrieben.

Bei der in Figur 3 dargestellten Ausbildung für den Ausgangstreiber OLB hat man zunächst einen durch die beiden Dateneingänge D und $\overline{D}$ gesteuertes Ausgangsregister OL (= output latch), das zudem durch einen Takt $\emptyset_0$ gesteuert ist. Hierzu kann man beispielsweise ein durch den Takt $\emptyset_0$ getaktetes Flip-Flop, insbesondere ein D-Latch, verwenden. Der das auszuwertende Datensignal Do und der das hierzu invertierte Signal $\overline{D}$o führende Ausgang des Ausgangsregisters OL dienen jeweils zur Steuerung des Gates der beiden MOS-Feldeffekttransistoren T1 und T2, die zueinander in Reihe geschaltet sind. Der eine stromführende Anschluß dieser Reihenschaltung liegt am Versorgungspotential $V_{CC}$ und ist durch den Drain des durch das auszuwertende Datensignal führenden Ausgang Do des Ausgangsregisters OL gesteuerten MOS-Feldeffekttransistors T1 gegeben. Der zweite stromführende Anschluß dieser Reihenschaltung ist durch den Sourceanschluß des durch das invertierte Datensignal führenden Ausgang $\overline{D}$o des Ausgangsregisters OL gesteuerten MOS-Feldeffekttransistors T2 gegeben und liegt am Bezugspotential $V_{SS}$. Zwischen den beiden Transistoren T1 und T2 der genannten Reihenschaltung liegt der Datenausgang DA des Speichers.

Zwei weitere MOS-Feldeffekttransistoren T3 und T4 dienen der Entladung je eines der beiden Datenausgänge Do bzw. $\overline{D}$o des Ausgangsregisters OL und damit des Gates des jeweils durch den betreffenden Datenausgang Do bzw. $\overline{D}$o gesteuerten Ausgangstransistors T1 bzw. T2. Dabei ist im gezeichneten Fall der Ausgang Do über die Source-Drainstrecke des Entladungstransistors T3 und der Ausgang $\overline{D}$o über die Sourse-Drainstrecke des Entladungstransistors T4 mit dem Bezugspotential $V_{SS}$ verbunden. Ihre Gates werden durch einen gemeinsamen Takt $\emptyset'_k$ gesteuert, der von einer ihrerseits durch den Spalten-Adreßtakt $\overline{CAS}$- gesteuerten Schaltungs-

Anordnung geliefert wird.

Diese besteht aus einem Schaltungsteil EG, der von dem Spalten-Adreßtakt $\overline{CAS}$ beaufschlagt ist und seinerseits einen Taktimpuls $\emptyset_k$ an ein Verzögerungsglied VG abgibt. Am Ausgang dieses Verzögerungsgliedes VG erscheint dann der für die Steuerung der beiden Entladetransistoren T3 und T4 benötigte Taktimpuls $\emptyset'_k$. Es hat sich nun gezeigt, daß gerade durch die Anwendung des Verzögerungsgliedes VG der angestrebte Effekt zustande kommt, während beim Fehlen dieses Verzögerungsglieds VG die von dem Schaltungsteil EG, dem sog. Entladegenerator, gelieferten Impulse $\emptyset_k$, wenn sie unmittelbar für die Steuerung der beiden Entladetransistoren T3 und T4 eingesetzt werden würden, lediglich zu den mit der bisher angewendeten Nibble-Mode-Steuerung verbundenen Zeiteffekten führen würden. Allerdings läßt sich die Erfindung auch noch auf eine andere Weise als durch ein Verzögerungsglied VG realisieren.

Zu erwähnen wäre noch, daß die beiden Ausgangstransistoren T1 und T2 sowie die beiden Entladetransistoren T3 und T4 selbstsperrende Transistoren vom gleichen Kanaltyp, insbesondere vom n-Kanal-Typ sind, was im allgemeinen auch für die übrigen Teile des Speichers sowie der in Figur 3 vorgesehenen Schaltungsteile gilt.

Die beiden Ausgangstransistoren T1 und T2 bilden mit dem zwischen ihnen liegenden und den Ausgang DA bildenden Schaltungsknoten einen im Tri-State-Betrieb arbeitenden Ausgangspuffer. Mit Hilfe des das Ausgangsregister OL steuernden Taktimpulses $\emptyset_0$ gelangen die aus der Speichermatrix SP kommenden Daten zum Ausgangspuffer T1, T2. Durch den Takt $\emptyset'_k$ werden die Ausgänge Do und $\overline{D}$o des Ausgangsregisters OL und damit das Gate der Ausgangstransistoren T1 und T2 auf Low, also auf das Bezugspotential $V_{SS}$, gezogen, wodurch der Datenausgang DA in den Tri-State-Zustand gelangt. Das zugehörige Zeitdiagramm ist aus Figur 3a zu ersehen.

Das Verzögerungsglied VG ist im vorliegenden Fall bevorzugt auf eine Verzögerungszeit von 15 nsec eingestellt und besteht z. B. aus einer geraden Anzahl hintereinander geschalteter Inverter, die z. B. unter Verwendung von n-Kanal-MOS-FET's mit selbstsperrenden Treibertransistoren aufgebaut sind. Sie bestehen z. B. jeweils aus einem mit seiner Source am Bezugspotential $V_{SS}$ liegenden und mit seinem Gate den Invertereingang bildenden-Treibertransistor, dessen Drainanschluß den Signalausgang des Inverters bildet und der über einen Lasttransistor mit dem Versorgungspotential $V_{DD}$ bzw. $V_{CC}$ verbunden ist. Ist der Lasttransistor vom selben Typ wie der Treibertransistor, so ist sein Gate mit seinem Drain verbunden. Ist der Lasttransistor hingegen vom selbstleitenden Typ, so liegt sein Gate bevorzug am Ausgang des betreffenden Inverters.

Hinsichtlich einer möglichen Ausgestaltung des Ausgangsregisters OL sowie des durch den Spalten-Adreßtakt $\bar{C}\bar{A}\bar{S}$ unmittelbar gesteuerten Schaltungsteils EG zur Erzeugung des an das Verzögerungsglied VG zu legenden Taktes $\emptyset_k$ kann auf Figur 3b hingewiesen werden. Die im übrigen hinsichtlich der Erzeung der die Entladetransistoren T3 und T4 gemeinsam steuernden Impulse $\emptyset'_k$ gegenüber der aus Figur 3 ersichtlichen Anlage weiter ausgestaltet ist.

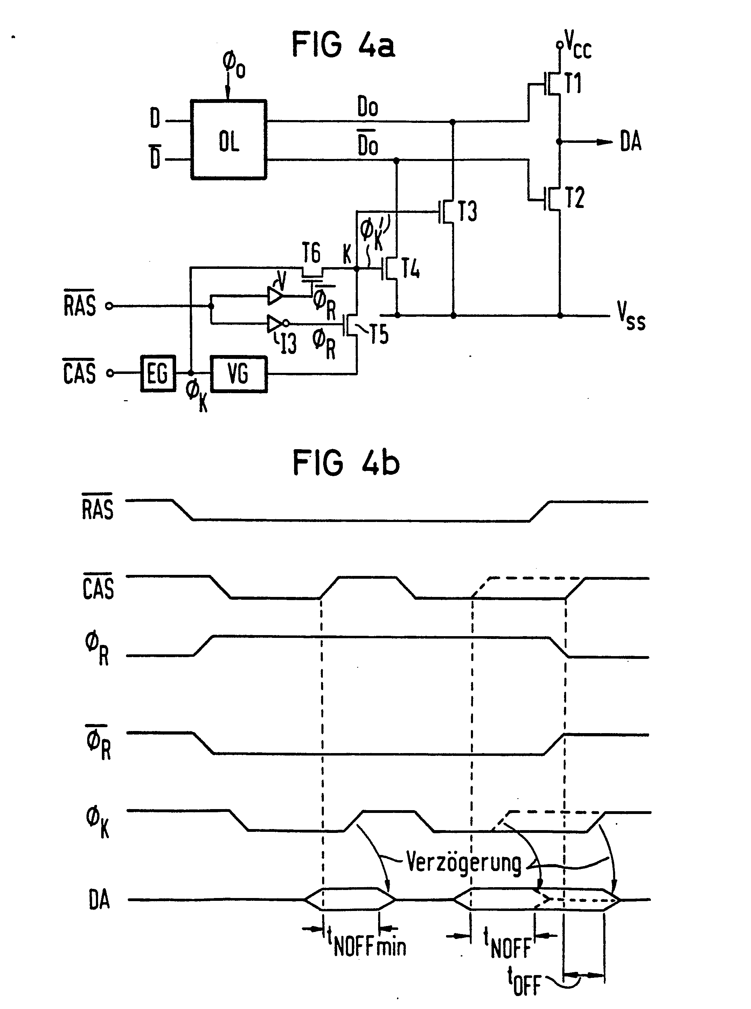

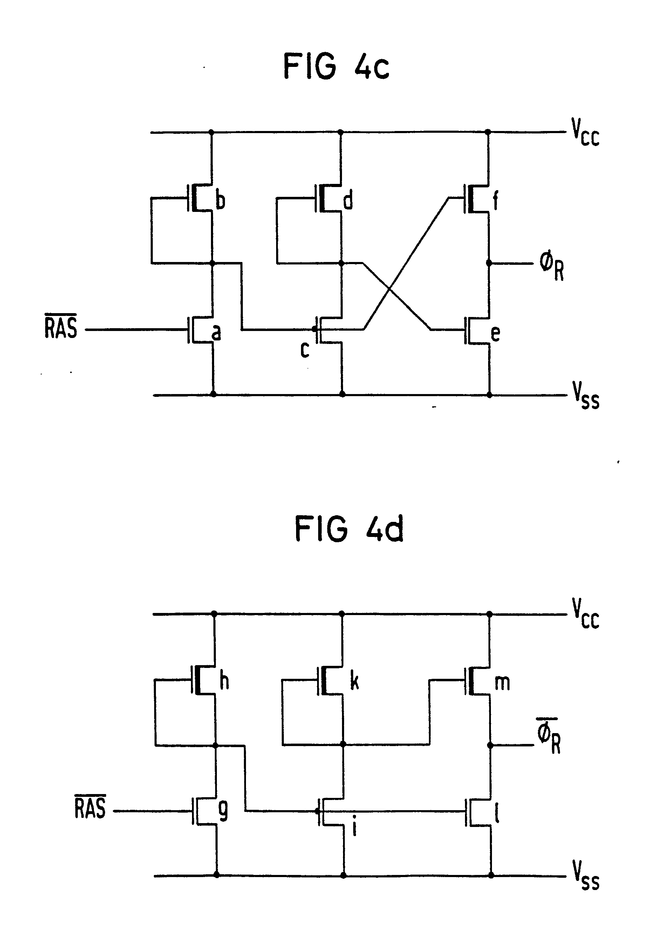

Das Ausgangsregister OL besteht in dem in Figur 3b gezeigten Beispielsfall aus einem Flip-Flop, welches aus den kreuzgekoppelten MOS-Feldeffekttransistoren 3 und 4, und den beiden Lasttransistoren 1 und 2 gebildet ist. Dabei liegen die Sourceanschlüsse der beiden kreuzgekoppelten MOS-FET's 3 und 4 am Bezugspotential $V_{SS}$ und der Drainamschluß des Transistors 3 sowie der Gateanschluß des Transistors 4 an der Source des Lasttransistors 1, während der Drainanschluß des Transistors 4 und der Gateanschluß des Transistors 3 mit der Source des Lasttransistors 2 unmittelbar verbunden ist. Die Drainanschlüsse der beiden Lasttransistoren sind von dem erwähnten Taktsignal $\emptyset_o$ und das Gate des ersten Lasttransistors 1 durch den Dateneingang D sowie das Gate des zweiten Lasttransistors 2 durch den invertierten Dateneingang $\bar{D}$ beaufschlagt. Demzufolge bildet der zwischen dem Transistor 3 und dem ersten Lasttransistor 1 liegende Schaltungsknoten den Ausgang Do für das nichtinvertierte Datensignal und der Knoten zwischen dem Transistor 4 und dem zweiten Lasttransistor 2 den Ausgang $\bar{D}\bar{o}$ für das invertierte Datensignal. Die aus Figur 3b ersichtliche Ausgestaltung für das Ausgangsregister OL kann sowohl bei der Ausgestaltung gemäß Figur 3 als auch bei der Ausgestaltung gemäß Figur 4 verwendet werden.

Hinsichtlich der Ansteuerung des Tri-State-Ausgangs T1, T2, und der Anschaltung der Entladungstransistoren T3 und T4 an die Ausgänge Do und $\bar{D}\bar{o}$ besteht gegenüber der Figur 3 und auch gegenüber den noch zu beschreibenden Ausgestaltungen der Erfindung kein Unterschied. Die Transistoren im Ausgangsregister OL sind ebenfalls selbstsperrende Transistoren vom selben Kanal-Leitungstyp wie die Transistoren T1 - T4.

Der der Erzeuguung des für die Steuerung des Verzögerungsgliedes VG vorgesehene Schaltungsteil EG, also der Entladegenerator, ist z. B. durch einen MOS-Verstärker bekannter Bauart gegeben, dessen Eingang durch das Spalten-Adreßtaktsignal $\bar{C}\bar{A}\bar{S}$ beaufschlagt ist und dessen Ausgang das Taktsignal $\emptyset_k$ liefert, das zur Beaufschlagung des Verzögerungsgliedes VG vorgesehen ist. Wie bereits oben angedeutet besteht das Verzögerungsglied VG in dem gezeichneten Beispielsfall aus zwei hintereinander geschalteten MOS-Invertern üblicher Bauart. Dabei ist der Ausgang des zweiten Inverters unmittelbar mit dem einen Eingang eines UND-Gatters U1 verbunden, während der zweite Eingang dieses UND-Gatters U1 unmittelbar durch den Ausgang des Schaltungsteiles EG, also von den Impulsen $\emptyset_k$, gesteuert ist. Am Ausgang dieses UND-Gatters U1 erscheinen die Impulse $\emptyset'_k$, die zur Steuerung der Entladung der beiden. Datenausgänge Do und $\bar{D}\bar{o}$ und des Gates der beiden Ausgangstransistoren T1 und T2 vermittels der Transistoren T3 und T4 dienen.

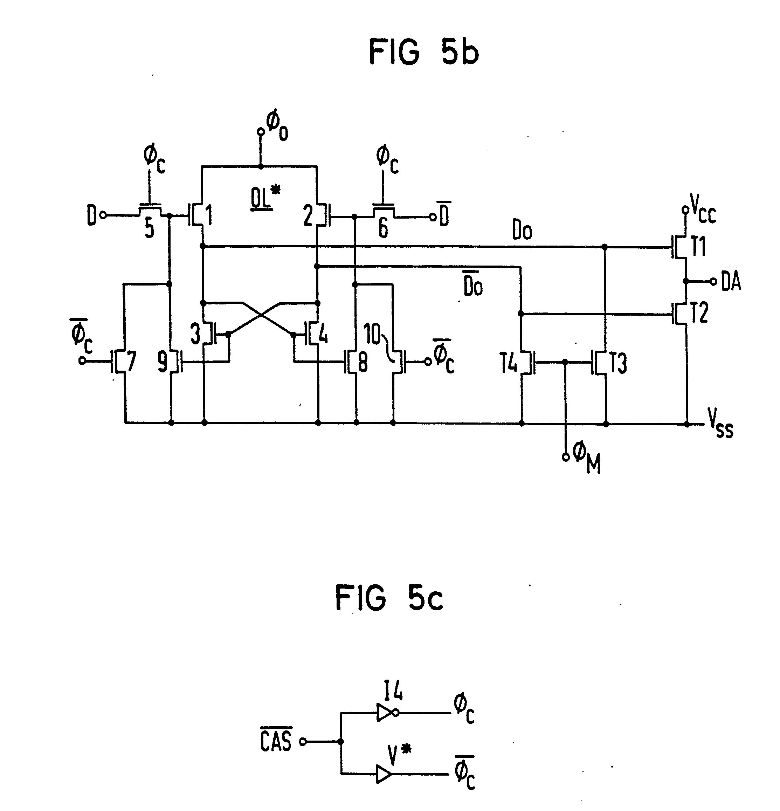

Das bei der Ausgestaltung gemäß Figur 3b vorgesehene UND-Gatter U1 bewirkt, daß nur die Aufwärtsflanke von $\emptyset'_k$ gegenüber $\emptyset_k$ verzögert wird, während die Abwärtsflanke keine solche Verzögerung erfährt. Außerdem ist anzustreben, daß die Ausgänge Do, $\bar{D}\bar{o}$ des Ausgangsregisters OL nicht durch den Takt $\emptyset_o$ auf den Pegel LOW gezogen werden, was auf verschiedene Weise erreichbar ist. Eine Möglichkeit ist bei der Ausgestaltung gemäß Figur 5b durch die Verwendung zusätzlicher Taktsteuerungen $\emptyset_C$ und $\bar{\emptyset}_C$ gegeben.

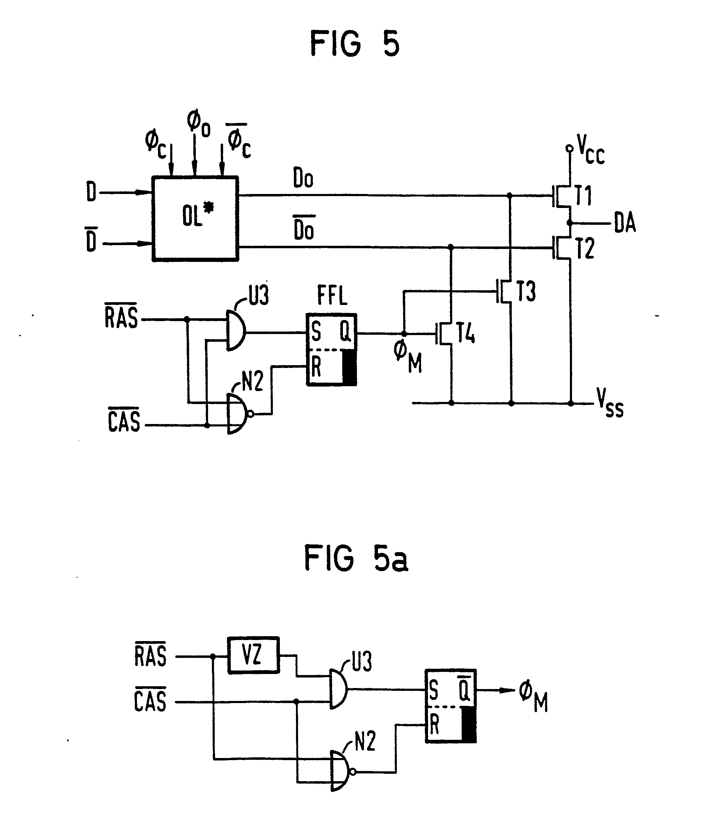

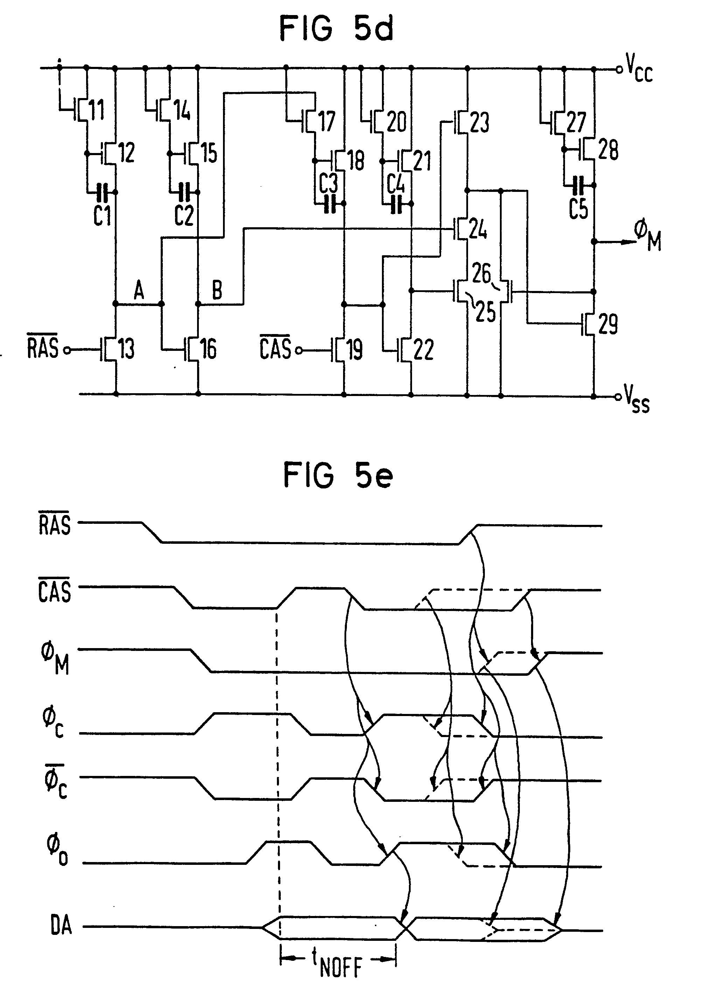

Hinsichtlich einer Möglichkeit der Erzeugung des für die Steuerung des Ausgangsregisters OL benötigten Taktimpulse $\emptyset_o$ wird auf die Figur 3c hingewiesen. Hier liegen die Zeilen-Adreßtaktsignale $\bar{R}\bar{A}\bar{S}$ an dem einen Signaleingang und die Spalten-Adreßtaktsignale $\bar{C}\bar{A}\bar{S}$ an dem anderen Signaleingang eines NOR-Gatters N1. Der Ausgang dieses NOR-Gatters N1 steuert den Setzeingang eines Flip-Flops FF, z. B. eines RS-Flip-Flops, dessen Reseteingang von den Zeilen-Adreßtaktsigalen $\bar{R}\bar{A}\bar{S}$ beaufschlagt ist. Der das nichtinvertierte Signal liefernde Ausgang Q des Flip-Flops FF ist über ein Verzögerungsglied I1I2 an den einen Eingang eines UND-Gatters U2 gelegt. Der zweite Eingang dieses UND-Gatters U2 ist durch den Ausgang eines Inverters I3 gesteuert, dessen Eingang durch das Spalten-Adreßtaktsignal $\bar{C}\bar{A}\bar{S}$ unmittelbar beaufschlagt ist. Der Signalausgang des UND-Gatters U2 liefert die gewünschten Taktimpulse $\emptyset_o$, die für die Taktsteuerung des Ausgangsregisters OL, z. B. in der aus Figur 3b ersichtlichen Weise, verwendet werden. Sie werden aber auch in derselben Weise wie in Figur 3b zur Steuerung der bei der Ausgestaltung gemäß Figur 5, 5a, 5b verwendeten Ausgestaltung für das Ausgangsregister OL* eingesetzt, wie aus Figur 5b ersichtlich ist.

Die in Figur 3c dargestellte Schaltung für die Erzeugung der Taktimpulse $\emptyset_o$ bewirkt, daß - nachdem der Zeilen- Adreßtakt $\bar{C}\bar{A}\bar{S}$ auf LOW gegangen ist - der erste $\emptyset_o$-Impuls mit einer zeitlichen Verzögerung gegenüber dem Spalten-Adreßtakt $\bar{C}\bar{A}\bar{S}$ auf HIGH geht. In dieser Zeit werden die Daten aus den Speicherzellen in der Matrix SP gelesen und im Zwischenregister Rg (vgl. Figur 2) abgespeichert. Die folgenden $\emptyset_o$-Impulse haben nur eine geringe Verzögerung gegenüber $\bar{C}\bar{A}\bar{S}$.

Bei der in Figur 4 bzw. 4a dargestellten Ausgestaltung einer der Erfindung entsprechenden Ausgangsstufe OLB ist die in Figur 3 dargestellte Version die Grundlage. Dabei ist folgendes Verhalten angestrebt:

Es soll eine gezielte Verlängerung der Speicherzeit des Datenausgangs DA (also der beiden Ausgangstransistoren T1 und T2) - und zwar beschränkt auf den Fall, daß die Speicherschaltung im Nibble-Mode oder im Byte-Mode betrieben wird - erreicht werden. Das bedeutet, daß eine solche Verlängerung der Speicherzeit nur dann gegeben ist, wenn beim Abschalten des Datenausgangs DA durch den Spalten-Adreßtakt $\bar{C}\bar{A}\bar{S}$ sich der Zeilen-Adreßtakt $\bar{R}\bar{A}\bar{S}$ auf dem Pegel LOW befindet, wie dies im einzelnen aus dem Zeitdiagramm gemäß Fig 4b ersichtlich ist. Dabei soll aber die bisher übliche kurze Speicherzeit für den Normalbetrieb mit dem Zeilen-Adreßtakt $\bar{R}\bar{A}\bar{S}$ auf dem Pegel HIGH beibehalten werden.

Für den Fall des Betriebs im Nibble-Mode oder im Byte-Mode soll (vgl. Figur 4b) somit

$$t_{NOFFmin} \geqslant t_{ST}$$

und im Normalbetrieb mit $\bar{R}\bar{A}\bar{S}$ = HIGH soll

$$t_{OFFmin} < t_{NOFFmin}$$

gelten. Dabei ist $t_{NOFF}$ die Zeitspanne die vergeht bis der Datenausgang DA abgeschaltet ist und mit dem Übergang des Spalten-Adreßtaktsignals von LOW nach HIGH beginnt, wobei der Zeilen-Adreßtakt $\bar{R}\bar{A}\bar{S}$ ebenfalls den Zustand LOW hat. Liegt hingegen der Zeilen-Adreßtakt $\bar{R}\bar{A}\bar{S}$ während des Abschaltens des Datenausgangs DA auf HIGH, so wird die oben angegebene Verzögerung nicht wirksam. Die ihr entsprechende Zeitspanne ist in der Figur 4b mit "$t_{OFF}$" bezeichnet.

Die in Figur 4 dargestellte Schaltung für den Ausgangstreiber OLB unterscheidet sich gegenüber der Schaltung gemäß Figur 3 bzw. 3b nur durch eine andere Struktur des der Erzeugung des die Gates der beiden Entladetransistoren T3 und T4 steuernden Takts $\emptyset'_k$ dienenden Teils der Ausgangsschaltung OLB. Dabei ist der die Impulse $\emptyset_k$ liefernde Ausgang des als Entladegenerator wirksamen und seinerseits vom Spalten-Adreßtakt $\bar{C}\bar{A}\bar{S}$ gesteuerten Schaltungsteils EG einerseits über die Reihenschaltung des Verzögerungsglieds VG und der Source-Drainstrecke eines Transfertransistors an einen Schaltungsknoten K gelegt. Andererseits ist derselbe Ausgang des Entladegenerators EG über einen zweiten Transfertransistor T6 ebenfalls an den besagten Knoten K angelegt. Zur Steuerung des Gates der beiden Transfertransistoren T5 und T6 ist ein durch dan Zeilen-Adreßtakt $\bar{R}\bar{A}\bar{S}$ gesteuerte Schaltung TG vorgesehen, welche zwei zueinander invertierte Taktsignale $\emptyset_R$ und $\bar{\emptyset}_R$ liefert. Dabei dient das eine Taktsignal $\emptyset_R$ zur Steuerung des Transistors T5 und damit der Verbindung zwischen dem Ausgang des Verzögerungsgliedes VG und dem besagten Knoten K. Das andere - zum ersten Taktsignal $\emptyset_R$ invertierte - Taktsignal $\bar{\emptyset}_R$ dient hingegen der Steuerung des Transfertransistors T6 und damit der Steuerung der unmittelbaren Verbindung zwischen dem Ausgang des Entladegenerators EG und dem besagten knoten K. An diesem Knoten K findet eine Überlagerung der einerseits am Ausgang des Verzögerungsglieds VG abgegebenen Impulsen mit den vom Entladegenerator EG gelieferten Impulsen $\emptyset_R$ statt. Durch diese Überlagerung entstehen die zur Steuerung des Gates der beiden Entladetransistoren T3, T4 dienenden Impulse. Der Zeitverlauf der Impulse $\emptyset_R$ und $\bar{\emptyset}_R$ inbezug auf die übrigen Impulse, insbesondere die Impulse $\bar{R}\bar{A}\bar{S}$ und $\bar{C}\bar{A}\bar{S}$, ist aus dem Zeitdiagramm gemäß Figur 4b zu ersehen.

Eine einfache Methode zur Erzeugung der für die Taktung der beiden Transfertransistoren T5 und T6 erforderlichen Impulse $\emptyset_R$ und $\bar{\emptyset}_R$ ist in Figur 4a dargestellt. Bei dieser wird zur Erzeugung der für die Steuerung des die Verbindung zwischen dem Knoten K und den Ausgang des Entladegenerators EG bildenden Transfertransistors T6 benötigten Impulse $\bar{\emptyset}_R$ der Zeilen-Adreßtakt $\bar{R}\bar{A}\bar{S}$ über einen nichtinvertierenden MOS-Verstärker V an das Gate des Transistors T6 gelegt. Andererseits dient zur Steuerung des Gates des die Verbindung zwischen dem Ausgang des Verzögerungsgliedes VG und dem Knoten K bildenden Transfertransistors ein Takt $\emptyset_R$, der durch die Beaufschlagung eines Inverters 13 durch den Zeilen-Adreßtakt $\bar{R}\bar{A}\bar{S}$ entsteht. Der Verstärker V kann z. B. (entsprechend dem Verzögerungsglied VG gemäß Figur 3b) durch zwei hintereinander geschaltete Inverter gegeben sein. Will man jedoch die Steuerung der beiden Transfertransistoren T5 und T6 einander zeitlich angleichen, so empfiehlt sich z. B. die aus Figur 4c und Figur 4d ersichtliche Version, wobei Figur 4c die Schaltung für den in der Ausführung gemäß Fig. 4a vorgesehenen Inverter 13 und die Figur 4d die Schaltung für den Verstärker V darstellt.

Da es sich bei den in Figur 4c und 4d dargestellten Schaltungen um an sich übliche Möglichkeiten handelt, einen invertierenden Verstärker und einen nichtinvertierenden Verstärker in MOS-Technik mit gleicher Verzögerungszeit zu realisieren und außerdem der angestrebte Effekt leicht ersichtlich ist, kann von einer detaillierten Beschreibung der Figuren 4c und 4d abgesehen werden. Zu bemerken ist lediglich, daß die mit ihrem Drain am Versorgungspotential liegenden Transistoren b, d, f, h, k, m vom Depletiontyp und die übrigen Transistoren a, c, e, g, i, l vom Enhencementtyp sind. Die beiden ersten Stufen a, b, c, d bzw. g, h, i, k bilden je einen Verstärker, während die Ausgangsstufe f, e bzw. m, l von den beiden ersten Stufen in der aus Figur 4c bzw. 4d ersichtlichen Weise gesteuert werden.

Die bisher beschriebenen Ausgestaltungen der Erfindung beruhen sämtlich auf der aus Figur 3 ersichtlichen Grundstruktur. Die anhand der folgendem Figuren zu beschreibenden Ausgestaltungen des der Erfindung entsprechenden Ausgangstreibers OLB haben mit den anhand von Fig. 3 usw. beschriebenen Ausgestaltungen nur den Tristate-Ausgang T1, T2 und die beiden Entladetransistoren T3 und T4 für das Gate des Transistors T1 bzw. T2 gemeinsam. Jedoch hinsichtlich der Ausbildung des Ausgangsregisters mit den Dateneingänge D bzw. $\bar{D}$ sowie der Erzeugung der Steuerimpulse für die beiden Entladetransistoren bestehen einige Unterschiede.

Die in Figur 5 dargestellte Ausbildung für den Ausgang OLB eines D-Speichers gemäß der Erfindung ist so ausgebildet, daß folgendem Verhalten gewährleisten ist;

Im Nibble-Mode- oder in Byte-Mode-Betrieb soll trotz des im Nibble-Mode auf HIGH liegenden Spalten-Adreßtaktes $\overline{CAS}$ der Datenausgang DA weiterhin noch zur Verfügung gehalten werden, und zwar so lange, bis der Spalten-Adreßtakt $\overline{CAS}$ wieder auf LOW geht und damit einen neuen Nibble-Mode- bzw. Byte-Mode-Zyklus startet. In der Zwischenzeit soll entweder überhaupt keine oder - bedingt durch das Umschalten - nur eine kurze Tristate-Phase des Datenausgangs DA gegeben sein. Außerdem soll am ende des jeweiligen Lesezklus (d.h. also, wenn sowohl das Spalten-Adreßsignal $\overline{CAS}$ als auch das Zeilen-Adreßsignal $\overline{RAS}$ auf dem Pegel HIGH liegen) der jeweils später auf dem Pegel HIGH liegende Adreßimpuls den Datenausgang DA abschalten, was z. B. mittels einer UND-Verknüpfung möglich ist.

Bei der in Figur 5 dargestellten und das soeben angegebene Verhalten bewirkenden Ausgestaltung des Datenausgangsteils OLB ist anstelle des bisherigen Registers OL als Ausgangsregister OL* ein sowohl durch die Impulse $\emptyset_0$ als auch durch zwei zueiander invertierte weitere Impulsfolgen $\emptyset_c$ und $\bar{\emptyset}_c$ gesteuertes Flip-Flop verwendet, das im Detail in Figur 5b dargestellt ist. Neben den zur die Taktung erforderlichen Signaleingängen und den beiden zueinander invertierten Dateneingängen D und $\bar{D}$ hat auch dieses Ausgangsregister zwei zueinander invertierte Datenausgänge Do und $\bar{D}$o, von denen der das nichtinvertierte Ausgangssignal führende Ausgang Do das Gate des an $V_{CC}$ liegenden MOS-Fet's T1 und der andere Ausgang $\bar{D}$o das Gate des an $V_{SS}$ liegenden MOS-FET's des Tri-State-Ausgangs T1, T2 steuert. Beide Datenausgänge Do und $\bar{D}$o sind jeweils wiederum über einen Entladungstransistor T3 bzw. T4 mit dem Bezugspotential $V_{SS}$ verbunden. Die Gates der beiden Entladetransistoren T3 und T4 werden gemeinsam durch einen Entladungsimpuls $\emptyset_M$ gesteuert.

Zur Erzeugung der Entladeimpulse $\emptyset_M$ wird bei der in Figur 5 dargestellten Datenausgangsschaltung gemäß eines Ausführungsbeispiels der Erfindung sowohl der Zeilen-Adreßtakt $\overline{RAS}$ als auch der Spalten-Adreßtakt $\overline{CAS}$ sowohl zur gemeinsamen Steuerung eines UND-Gatters U3 als auch zur gemeinsamen Steuerung eines NOR-Gatters N2 verwendet. Dabei liegt der Ausgang des UND-Gatters U3 am Setzeingang und der Ausgang des NOR-Gatters N2 am Reseteingang eines gemeinsamen RS-Flip-Flops FFL, dessen nichtinvertierender Ausgang Q die für die Steuerung des Gates der beiden Entladetransistoren T3 und T4 benötigten Impulse $\emptyset_M$ liefert.

Das für die Schaltung gemäß Figur 5 maßgebende Zeitdiagramm ist in Figur 5e dargestellt. Zur Erzeugung der Taktimpulse $\emptyset_o$ kann man die bereits anhand der Figur 3c vorgestellte Schaltung verwenden, während man zur Erzeugung der Taktimpulse $\emptyset_c$ und $\bar{\emptyset}_c$ entsprechend Figur 5c vorgehen kann. Hier hat man zur Erzeugung des Taktes $\emptyset_c$ einen Inverter I4, dessen Eingang durch den Spalten-Adreßtakt $\overline{CAS}$ beaufschlagt ist. Zur Erzeugung des invertierten Taktes hat man einen auf seiner Eingangsseite mit dem Spalten-Adreßtakt $\overline{CAS}$ beaufschlagten Verstärker V*. Auch hier kann man im Interesse gleicher Laufzeiten für den Inverter I4 die in Figur 4c und für den Verstärker V* die in Figur 4d dargestellte MOS-Schaltung verwenden.

Man kann nun die in Figur 5 dargestellte Schaltung hinsichtlich der der Erzeugung des Entladetakts $\emptyset_M$, dienenden Anlage weiter ausgestalten, indem man den Zeilen-Adreßtakt $\overline{RAS}$ über ein Verzögerungsglied VZ an das UND-Gatter U3 legt, während - wie Figur 5a zegt - die in Figur 5 verwendete Schaltung zur Beaufschlagung des RS-Flip-Flops FFL im übrigen unverändert ist. Dieses Verzögerungsglied VZ kann wiederum, durch zwei in Serie geschaltete Inverter gegeben sein Das Verzögerungsglied VZ führt, wie man ohne Weiteres einsehen kann, dazu, daß das Abschalten des am Datenausgang DA anhängigen Datensignals durch den Zeilen-Adreßtakt $\overline{RAS}$ eine weitere Verzögerung erfährt.

In Figur 5b ist die Schaltung für das Ausgangsregister OL*, wie es im Zusammenhang mit Figur 5 benötigt wird, dargestellt. Der Kern ist auch hier das aus den Transistoren 1-4 bestehende Flip-Flop OL gemäß Figur 3b für das Ausgangsregister OL. Um jedoch das gewünschte und in Figur 5e dargestellte Timing zu erreichen, sind noch weitere MOS-Feldeffekttransitoren 5 - 10 vom selben Typ wie die Transistoren 1 - 4 sowie T1 - T4 (d.h. also vom Enhencementtyp mit übereinstimmender Kanaldotierung) vorgesehen. Außerdem benötigt man die beiden Taktfolgen $\emptyset_C$ und $\bar{\emptyset}_C$, die zueinander invertiert und - wie bereits erwähnt - mittels einer Schaltung gemäß Figur 5c durch den Spalten-Adreßtakt $\overline{CAS}$ erzeugt werden können.

Wie aus Figur 5b ersichtlich ist der Dateneingang D über einen vom Takt $\emptyset_C$ gesteuerten-Transfertransistors 5 einerseits an das Gate des Transistors 1 des Flip-Flops gelegt und außerdem über zwei einander parallel geschaltete MOS-FET's 7 und 9 an das Bezugspotential $V_{SS}$ gelegt. Desgleichen ist der mit dem invertierten Datensignal beaufschlagte Dateneingang $\bar{D}$ über einen - ebenfalls vom Takt $\emptyset_C$ gesteuerten - Transfertransistor 6 einerseits an das Gate des Transistors 2 des Flip-Flops gelegt und außerdem durch die Parallelschaltung der beiden MOS-FET's 8 und 10 mit dem Bezugspotential $V_{SS}$ verbunden. Von den beiden Transistoren der beiden zuletzt genannten Parallelschaltungen 7, 9 bzw. 8, 10 ist jeweils ein Transistor (im Beispielsfall der Transiator 7 und 10) durch das invertierte Taktsignal $\bar{\emptyset}_C$ gesteuert. Das Gate des jeweils anderen MOS-Feldeffekttransistors der besagten Parallelschaltung ist mit demjenigen Datenausgang $\bar{D}\bar{o}$ bzw. Do das Ausgangsregisters OL* verbunden, der zu demjenigen der beiden Dateneingänge D bzw. $\bar{D}$ gehört, der über die Serienschaltung seines Eingangstransistors 5 bzw. 2 mit der betreffenden Transistor-Parallelschaltung 7, 9 bzw. 8, 10 an das Bezugspotential jeweils gelegt ist.

In Figur 5d ist eine Ein-Kanal-MOS-Schaltung zur Erzeugung des Entladetakts $\emptyset_M$ dargestellt die im Prinzip der in Figur 5 angegebenen Schaltung zur Erzeugung des Takts $\emptyset_M$ entspricht.

Die in Figur 5d dargestellte Schaltung zur Erzeugung des Taktes $\emptyset_M$ besteht aus den Transistoren 11 - 29 und 5 Kondensatoren C1 - C5. Die Transistoren sind vom gleichen Kanaltyp wie die übrigen in der Schaltung verwendeten Transistoren und bevorzugt selbstsperrend.

Bei dieser Schaltung steuert der Zeilen-Adreßtakt $\bar{R}\bar{A}\bar{S}$ den ersten Transistor 13 dieser Schaltung, der mit seiner Source am Bezugspotential $V_{SS}$, und mit seinem Drain über eine durch die beiden MOS-Feldeffekttransistoren 11 und 12 sowie dem Kondensator C1 gebildete Bootstrap-Last an das Versorgungspotential $V_{CC}$ angeschaltet ist. Dadurch kommt eine Inverterwirkung zustande, wobei jedoch das Ausgangssignal einen High-Ausgangspegel hat, der gleich der Versorgungsspannung ist.

Eine zweite Bootstrapinverterstufe ist in gleicher Weise wie die erste Bootstrapinverterstufe aufgebaut und ist am Gate ihres Treibertransistors 16 durch den Ausgang A der ersten Inverterstufe gesteuert. Die aus den beiden Transistoren 14 und 15 und dem Kondensator C2 aufgebaute Bootstraplast entspricht, ebenso wie die übrige Schaltung der ersten Bootstrapinverterstufe.

Ein dritter Bootstrapinverter hat einen Treibertransistor 79, der durch den Spalten-Adreßtakt $\bar{C}\bar{A}\bar{S}$ gesteuert ist. Außerdem ist die Bootstraplast dieses Inverters über den einen Bestandteil dieser Last bildenden MOS-Feldeffekttransistor 17 über dessen Drain vom Ausgang A der ersten Bootstrapinverterstufe in der aus Figur 5d ersichtlichen Weise vorgeladen. Im übrigen entspricht der Aufbau des Lastelements der dritten Inverterstufe dem Aufbau der Last bei den übrigen Inverterstufen dieser Schaltung. Ein vierter Bootstrapinverter wird an seinem Treibertransistor 22 durch den Ausgang der dritten Inverterstufe 19, 17, 18 gesteuert. Bezüglich der Schaltung der Bootstraplast sind die erste, die zweite und die vierte Bootstrapinverterschaltung identisch, während die dritte Inverterstufe hinsichtlich der Steuerung der Last durch den Ausgang A des ersten Inverters geringfügig, wie aus der Figur 5d ersichtlich, abweicht. Eine aus dem Treibertransistor 29 und der Bootstraplast 27, 28 und C5 aufgebaute Inverterstufe bildet den Signalausgang der Schaltung. Das gewünschte Signal $\emptyset_M$ ist am Drain des Treibertransistors 29 dieser fünften Inverterstufe abnehmbar.

Die fünfte Inverterstufe wird an ihrem Treibertransistor durch eine aus den Transistoren 23 - 26 gebildete Vorstufe gesteuert, die ihrerseits einerseits durch den Ausgang der zweiten Inverterstufe, also dem Ausgang B, andererseits durch den Ausgang der dritten und der vierten Inverterstufe gesteuert und schließlich durch den Signalausgang der fünften Inverterstufe gegengekoppelt ist. Hierzu ist der mit seinem Drain am Versorgungspotential $V_{CC}$ liegende Transistor 23 dieser Zwischenstufe durch den Ausgang der dritten Inverterstufe, also dem Drain des durch $\bar{C}\bar{A}\bar{S}$ gesteuerten Treibertransistors 19 gesteuert, indem sein Gate mit diesem Ausgang verbunden ist. An der Source des Transistors 23 der Zwischenstufe liegt der Drain eines Transistors 26, dessen Sourse am Bezugspotential $V_{SS}$ und dessen Gate am Drain des Treibertransistors 23 der letzten Inverterstufe liegt. Außerdem ist die Source des Transistors 23 der Zwischenstufe über die Serienschaltung zweier weiterer Transistoren 24 und 25 mit dem Bezugspotential verbunden, wobei der am Bezugspotential unmittelbar liegende Transistor 25 durch den Ausgang der vierten Inverterstufe, also dem Drain des Treibertransistors 22, und der unmittelbar an der Source des Transistors 23 liegende Transistor 24 an seinem Gate durch den Ausgang der zweiten Inverterstufe, also dem Drain des Transistors 16 gesteuert ist.

Die beschriebenen Ausführungsbeispiele der Erfindung haben die Eigenschaft, sich mit einem geringen Aufwand bezüglich der Taktung darstellen zu lassen.

## Patentansprüche

1. Integrierte Halbleiterschaltung mit einem dynamischen Schreib-Lese-Speicher, bei dem die aus einander gleichen Speicherzellen, insbesondere Ein-Transistor-Speicherzellen, aufgebaute Speichermatrix (SP) über Zeilen- und Spaltendekoder hinsichtlich der einzelnen Speicherzellen adressierbar und dabei die Adressierung nach den einzelnen Matrixzeilen durch einen Zeilen-Adreßtakt ($\bar{R}\bar{A}\bar{S}$) und die Adressierung nach den einzelnen Matrixspalten durch einen Spalten-Adreßtakt ($\bar{C}\bar{A}\bar{S}$) eingeleitet ist, bei der die Adressierung derart ausgestaltet ist, daß beim Auslesevorgang gleichzeitig die Information von mindestens zwei der für die Datenspeicherung vorgesehenen Speicherzellen verarbeitet und in einem Zwischenregister (Rg) zwischengespeichert wird, und außerdem ein ausschließlich durch den Spalten-Adreßtakt (C̄ĀS̄) betriebenes Schieberegister (RS) für die serielle Übertragung der gleichzeitig aus der Speichermatrix erhaltenen Informationen an den Datenausgang (DA) des Speichers vorgesehen ist und bei der in einer als Normalbetrieb bezeichneten ersten Betriebsart, bei der mit einem HIGH-Betriebszustand des Zeilen-Adreßtaktes (R̄ĀS̄) ein Abschalten des Datenausganges (DA) durch den Spalten-Adreßtakt (C̄ĀS̄) verbunden ist, dieses Abschalten des Datenausganges (DA) ohne Verzögerung beim Übergang des Spalten-Adreßtaktes (C̄ĀS̄) in den HIGH-Zustand erfolgt, dadurch gekennzeichnet, daß die Steuerung des Datenausgangs (DA) über den Spalten-Adreßtakt (C̄ĀS̄) derart ausgebildet ist, daß die jeweils am Datenausgang (DA) anhängige und durch das Schieberegister (RS) zur Verfügung gestellte Dateninformation nach dem Abklingen des ihre Auslesung veranlassenden Spalten-Adreßtaktsignals (C̄ĀS̄) noch eine - gegebenenfalls bis zum Einsetzen des nächsten Spalten-Adreßtaktsignals (C̄ĀS̄) reichende - definierte Zeitspanne am Datenausgang (DA) des Speichers erhalten bleibt, und daß die so erzielbare Verlängerung der Verfügbarkeit der Dateninformation am Datenausgang (DA), gesteuert über den Zeilen-Adreßtakt (R̄ĀS̄), in einer zweiten Betriebsart der Halbleiterschaltung wirksam ist, bei der beim Übergang des Spalten-Adreßtaktes (C̄ĀS̄) in den HIGH-Zustand sich gleichzeitig der Zeilen-Adreßtakt (R̄ĀS̄) auf LOW-Pegel befindet.

2. Integrierte Halbleiterschaltung nach Anspruch 1, dadurch gekennzeichnet, daß die Wirksamkeit der Verlängerung und deren Unwirksamkeit durch entsprechende Ausgestaltung eines den Datenausgang (DA) des Speichers aufweisenden Ausgangsteils (OLB) erreicht ist.

3. Halbleiterschaltung nach Anspruch 1 oder 2, dadurch gekennzeichnet, daß der den Datenausgang (DA) des Speichers aufweisende und durch die mit den Spaltenleitungen der Speichermatrix (SP) gekoppelten Zwischenregister (RG) in einer durch den Spalten-Adreßtakt (C̄ĀS̄) gesteuerten Weise mit zu einander invertierten Datensignalen (D, D̄) beaufschlagte Ausgangsteil (OLB) des Speichers zwei einander gleiche Ausgangstransistoren (T1, T2) sowie ein taktgesteuertes und die erhaltenen Datensignale an die beiden Ausgangstransistoren (T1, T2) weiterleitendes Ausgangsregister enthält, daß hierbei die beiden Ausgangstransistoren (T1, T2) eine - einerseits am Versorgungspotential (V$_{CC}$) und andererseits am Bezugspotential liegende und zwischen den beiden Transistoren den Datenausgang (DA) aufweisende - Reihenschaltung bilden, wobei das Gate des einen Ausgangstransistors (T1) mit dem das nichtinvertierte Datensignal liefernden Ausgang (Do) und das Gate des anderen Ausgangstransistors (T2) mit dem das invertierte Datensignal liefernden Ausgang (D̄o) des Ausgangsregisters (OL, OL*) unmittelbar verbunden ist, daß außerdem die beiden Datenausgänge (Do, D̄o) des Ausgangsregisters (OL, OL*) über je einen dirch ein weiteres gemeinsames Taktsignal (Ø'$_k$, Ø$_M$) gesteuerten MOS-Entladetransistor (T3 bzw T4) mit dem Bezugspotential (V$_{SS}$) verbunden sind, und daß schließlich zur Erzeugung des Steuertaktes für die beiden Entladetransistoren (T3, T4) ein durch den Spalten-Adreßtakt (C̄ĀS̄) sowie den Zeilenadreßtakt (R̄ĀS̄) beaufschlagter Impulsformer sowie zur Erzeugung des Taktes (Ø$_o$) für das Ausgangsregister (OI, OL*) ein sowohl durch den Spalten-Adreßtakt als auch vom Zeilen-Adreßtakt gesteuerter weiterer Impulsformer vorgesehen ist.

4. Halbleiterschaltung nach Anspruch 3, dadurch gekennzeichnet, daß im Ausgangsregister das Gate eines ersten MOS-Feldeffekttransistors (1) und das Gate eines zweiten MOS-Feldeffekttransistors (2) durch je einen der beiden die zueinander invertierten Daten führenden Eingänge (D, D̄) des Ausgangsregisters (OL, OL*) beaufschlagt und die beiden MOS-Feldeffekttranssistoren (1, 2) an ihrem Drain in gleicher Weise durch den das Ausgangsregister (OL, OL') steuernden Takt (Ø$_o$) beaufschlagt sind, daß außerdem der Sourceanschluß jedes der beiden MOS-Feldeffekttransistoren (1, 2) sowohl je einen der beiden Datenausgänge (Do, D̄o) des Ausgangsregisters (OL, OL*) bildet als auch mit dem Drain je eines weiteren MOS-Feldeffekttransistors (3, 4) verbunden ist, wobei der Sourceanschluß dieser beiden weiteren Transistoren (3, 4) am Bezugspotential (V$_{ss}$) und ihr Gate am Drain des jeweils anderen dieser beiden Transistoren (3, 4) liegt.

5. Halbleiterschaltung nach Anspruch 4, dadurch gekennzeichnet, daß zur Erzeugung des zur Steuerung des Ausgangsregisters (OL, OL*) vorgesehenen Taktsignals (Ø$_o$) ein sowohl vom Zeilen-Adreßtakt (R̄ĀS̄) als auch vom Spalten-Adreßtakt (C̄ĀS̄) gesteuertes NOR-Gatter (N1) zur Beaufschlagung des Setzeingangs (S) eines RS-Flip-Flops (FF) vorgesehen ist, dessen nichtinvertierter Ausgang (Q) über ein - z. B. mittels Inverter (I1, I2) gebildetes - Verzögeiungsglied an den Eingang eines die gewünschten Taktsignale (Ø$_o$) liefernden UND-Gatters (U2) gelegt ist, während der andere Eingang dieses UND-Gatters (U2) unter Vermittlung eines Inverters (I3) durch den Spalten-Adreßtakt (C̄ĀS̄) gesteuert und der Reset (R) des RS-Flip-Flops (FF) unmittelbar an den Zeilen-Adreßtakt (R̄ĀS̄) gelegt ist (Fig. 3c).

6. Halbleiterschaltung nach Anspruch 4 oder 5, dadurch gekennzeichnet, daß die Dateneingänge (D, D̄) des Ausgangsregisters (OL) unmittelbar durch das Gate je eines der beiden an ihrem Drain durch das Taktsignal (Ø$_o$) beaufschlagten

MOS-Feldeffekttransistoren (1, 2) gegeben sind.

7. Halbleiterschaltung nach Anspruch 4 oder 5, dadurch gekennzeichnet, daß die Datenausgänge (D, D̄) des Ausgangsregisters (OL*) durch den Sourceanschluß je eines weiteren MOS-Feldeffekttransistors (5, 6) gegeben sind, daß dabei das Gate dieser weiteren MOS-Feldeffekttransistoren (5, 6) von einem gemeinsamen zweiten Taktsignal (Ø$_C$) gesteuert ist, während ihr Drainanschluß am Gate je eines der beiden an ihrem Drain gemeinsam durch das erste Taktsignal (Ø$_0$) gesteuerten MOS-Feldeffekttransistoren (1, 2) liegt, daß außerdem das Gate dieser durch das erste Taktsignal (Ø$_0$) gesteuerten MOS-Feldeffekttransistoren (1, 2) über je eine Parallelschaltung zweier weiterer MOS-Feldeffekttransistoren (7, 9 bzw. 8, 10) mit dem Bezugspotential (V$_{SS}$) verbunden ist und daß dabei je ein MOS-Feldeffekttransistoren (9 bzw. 8) jeder dieser beiden Parallelschaltungen mit seinem Gate unmittelbar an dem Sourceanschluß desjenigen der beiden durch das erste Taktsignal (Ø$_0$) beaufschlagten Feldeffekttransistoren (2, 1) liegt, dessen Gate über die jeweils andere Parallelschaltung (8, 10 bzw. 7, 9) mit dem Bezugspotential (V$_{SS}$) verbunden ist, während für die Steuerung der beiden anderen Transistoren (7, 10) ein gemeinsames drittes Taktsignal (Ø̄$_C$) vorgesehen ist, dessen zeitlicher Verlauf zu dem des zweiten Taktsignals (Ø$_C$) invertiert ist.

8. Halbleiterschaltung nach Anspruch 7, dadurch gekennzeichnet, daß zur Erzeugung des zweiten und des dritten Taktsignals (Ø$_C$, Ø̄$_C$) der Zeilen-Adreßtakt (C̄ĀS̄) über einen das zweite Taktsignal (Ø$_C$) liefernden Inverter (I4) bzw. über einen - insbesondere dieselbe Verzögerung wie das dritte Taktsignal (Ø̄$_C$) liefernden Verstärker (V*) geführt ist.

9. Halbleiterschaltung nach einem der Ansprüche 3 bis 8, dadurch gekennzeichnet, daß die die zur Steuerung der Entladetransistoren (T3, T4) dienenden Taktimpulse (Ø'$_K$) liefernde und durch den Spalten-Adreßtakt (C̄ĀS̄) sowie den Zeilen-Adreßtakt (R̄ĀS̄) gesteuerte Anlage aus einem - z. B. durch einen nichtinvertierenden Verstärker gegebenen - Eingangsteil (EG) und einem durch dessen Ausgang gesteuerten Verzögerungsglied (VG) besteht, wobei der Eingangsteil (EG) unmittelbar durch den Spalten-Adreßtakt (C̄ĀS̄) beaufschlagt ist.

10. Halbleiterschaltung nach Anspruch 2 und 9, dadurch gekennzeichnet, daß zur Beaufschlagung des Gates der beiden Entladungstransistoren (T3 T4) ein Schaltungsknoten (K) vorgesehen ist, der einerseits unmittelbar vom Ausgang des seinerseits durch den Spalten-Adreßtakt (C̄ĀS̄) gesteuerten Eigangsteils (EG) der die Impulse (Ø'$_K$) für die Steuerung der Entladetransistoren (T3, T4) liefernden Anlage und andererseits vom Ausgang des Verzögerungsglieds (VG) jeweils unter Vermittlung eines Transfertransistors (T6, T5) beaufschlagt ist, und daß das Gate der beiden Transfertransistoren (T5, T6) durch

zueinander invertierte Impulse (Ø$_R$ bzw. Ø̄$_R$) gesteuert ist und daß diese Impulse (Ø$_R$, Ø̄$_R$) durch den Zeilen-Adreßtakt (R̄ĀS̄) mittels eines Impulsformers (TG) erzeugt sind.

11. Halbleiterschaltung nach Anspruch 10, dadurch gekennzeichnet, daß der Impulsformer (TG) einerseits durch einen mit seinem Ausgang an das Gate des die Verbindung zwischen dem Ausgang des Eingangsteils (EG) und dem Schaltungsknoten (K) steuernden Transfertransistors (T6) angeschlossenen nichtinvertierenden Verstärker (V) und andererseits durch einen mit seinem Ausgang an das Gate des die Verbindung zwischen dem Ausgang des Verzögerungsglieds (VG) und dem Schaltungsknoten (K) steuernden Transfertransistors (T5) angeschlossenen invertierenden Verstärkers (I3) gegeben und der Eingang der beiden Verstärker (V, I3) gemeinsam durch den Zeilen-Adreßtakt (R̄ĀS̄) beaufschlagt ist.

12. Halbleiterschaltung nach Anspruch 11, dadurch gekennzeichnet, daß der invertierende Verstärker (I3) und der nichtinvertierende Verstärker (V) auf eine gleiche Verzögerungszeit eingestellt sind.

13. Halbleiterschaltung nach einem der Ansprüche 2, 3 und 7, dadurch gekennzeichnet, daß der den Datenausgang (DA) aufweisende Ausgangsteil (OLB) des Speichers derart ausgestaltet ist, daß in der zweiten Betriebsart der Halbleiterschaltung der Datenausgang (DA) trotz Abschalten des Spalten-Adreßtakts (C̄ĀS̄) auf HIGH verfügbar bleibt, und zwar solange, bis der Spalten-Adreßtakt (C̄ĀS̄) wieder auf den Pegel LOW geht und damit einen neuen Nibble- bzw. Byte-Mode-Zyklus startet, daß außerdem eine Tristate-Phase des Datenausgangs (DA) höchstens für eine im Vergleich zur Dauer der einzelnen aktiven Phasen des Spalten-Adreßtakts (C̄ĀS̄) kürzeren Zeitspanne gegeben ist, und daß schließlich am Ende jedes Lesezyklus wenn sowohl der Zeilen-Adreßtakt (R̄ĀS̄) als auch der Spalten-Adreßtakt (C̄ĀS̄) auf HIGH liegt der jeweils später die aktive Phase beendende, d.h. den Pegel HIGH erreichende Adreßtakt den Datenausgang (DA) abschaltet.

14. Halbleiterschaltung nach Anspruch 7 und 13, dadurch gekennzeichnet, daß die zur Steuerung der beiden die beiden Datenausgänge (Do, D̄o) des Ausgangsregisters (OL*) mit dem Bezugspotential (V$_{SS}$) verbindenden Entladetransistoren (T3, T4) vorgesehenen Steuerimpulse (Ø$_M$) vom nichtinvertierenden Signalausgang (Q) eines Flip-Flops (FFL) abgegeben werden, dessen Setzeingang (S) durch den Ausgang eines UND-Gatters (U3) und dessen Reseteingang (R) durch den Ausgang eines NOR-Gatters (N2) gesteuert ist, und die gemeinsam an ihren beiden Signaleingängen sowohl durch den Spalten-Adreßtakt (C̄ĀS̄) als auch durch den Zeilen-Adreßtakt (R̄ĀS̄) gesteuert sind.

15. Halbleiterschaltung nach Anspruch 14, dadurch gekennzeichnet, daß sowohl das UND-Gatter (U3) als auch das NOR-Gatter (N2) unmittelbar sowohl durch den Spalten-Adreßtakt (C̄ĀS̄) als auch durch den Zeilen-Adreßtakt (R̄ĀS̄) gesteuert sind.

16. Halbleitsrschaltung nach Anspruch 14, dadurch gekennzeichnet, daß die Beaufschlagung des UND-Gatters (U3) und des NOR-Gatters (N2) durch den Spalten-Adreßtakt (C̄ĀS̄) unmittelbar und auch die Beaufschlagung des NOR-Gatters (N2) durch den Zeilen-Adreßtakt (R̄ĀS̄) unmittelbar erfolgt, während der Zeilen-Adreßtakt (R̄ĀS̄) an den ihm zugeteilten Eingang des UND-Gatters (U3) unter Vermittlung eines Verzögerungsgliedes (VZ) angelegt ist.

17. Halbleiterschaltung nach Anspruch 7 und 16, dadurch gekennzeichnet, daß zur Erzeugung der zur Steuerung der beiden Entladstransistoren (T3, T4) benötigten Taktimpulse ($\varnothing_M$) eine aus 5 Inverterstufen mit Bootstrap-Last und eine Zwischenstufe vorgesehen ist, daß dabei der Treibertransistor (13) der ersten Bootstrap-Inverterstufe (13, 11, 12, C1) durch den Zeilen-Adreßtakt (R̄ĀS̄) und der Treibertransistor (16) der zweiten Bootstrap-Inverterstufe (16, 14, 15, C2) durch den durch den Drain des Treibertransistors (13) der ersten Bootstrap-Inverterstufe gebildeten Signalausgang (A) dieser Inverterstufe gesteuert ist, daß außerdem die erste Inverterstufe mit ihrem Ausgang (A) zur Steuerung einer Vorladung der Bootstrap-Last (17, 18, C3) einer dritten Inverterstufe vorgesehen und der Treibertransistor (19) dieser dritten Inverterstufe durch den Spalten-Adreßtakt (C̄ĀS̄) gesteuert ist, daß weiterhin die vierte Bootstrap-Inverterstufe (22, 20, 21, C4) durch den Ausgang der dritten Bootstrap-Inverterstufe (19, 17, 18, C3) gesteuert ist, daß ferner die Zwischenstufe aus drei hintereinander geschalteten MOS-Feldeffekttransistoren (23, 24, 25) besteht, von denen der erste Transistor (23) mit seinem Drain am Versorgungspotential ($V_{CC}$) und mit seinem Gate am Ausgang der durch den Spalten-Adreßtakt (C̄ĀS̄) gesteuerten dritten Inverterstufe liegt, während sein den Ausgang der Zwischenstufe bildender Sourceanschluß einerseits zur Steuerung einer fünften Bootstrap-Inverterstufe (29, 27, 28, C5) gesehen und anderseits sowohl über einen weiteren, vom Ausgang der fünften Inverterstufe rückgesteuerten MOS-Feldeffekttransistor (26) als auch über die Serienschaltung zweier MOS-Feldeffekttransistoren (24, 25) in parallelegeschalteter Weise mit dem Bezugspotential ($V_{ss}$) verbunden ist, und daß schließlich die Bootstrap-Inverterstufen mit ihrer Last am Versorgungspotential ($V_{CC}$) sowie mit ihrem Treibertransistor am Bezugspotential ($V_{SS}$) liegen und der die für die Steuerung der Entladetransistoren (T3 T4) benötigten Taktimpulse ($\varnothing_M$) liefernde Ausgang durch den Drain des Treibertransistors (29) der letzten Bootstrap-Inverterstufe (29, 27, 28, C5) gegeben ist.

18. Halbleiterschaltung nach einem der vorgehenden Ansprüche, dadurch gekennzeichnet, daß die in ihr verwendeten Schaltungsteile in Ein-Kanal-MOS-Technik, insbesondere in n-Kanal-MOS-Technik, dargestellt sind.

**Claims**

1. An integrated semiconductor circuit with a dynamic write-read store, wherein the storage matrix (SP), which is contructed from identical storage cells, in particular one-transistor storage cells, can be addressed via row and column decoders in respect of the individual storage cells, and where the addressing in respect of the individual matrix rows is initiated by a row address strobe (R̄ĀS̄), and the addressing in respect of the individual matrix columns is initiated by a column address strobe (C̄ĀS̄), where the addressing is contrived to be such that, in the read process, the information of at least two of the storage cells provided for the data storage is simultaneously processed and intermediately stored in an internediate register (Rg), and moreover, a shift register (RS), operated exclusively by the column address strobe (C̄ĀS̄), is provided for the series transmission of the information items, obtained simultaneously from the storage matrix, to the data output (DA) of the store, and where, in a first operating mode, referred to as normal operation, in which a HIGH operating level of the row address strobe (R̄ĀS̄) is associated with the disconnection of the data output (DA) by the column address strobe (C̄ĀS̄), this disconnection of the data output (DA) takes place without delay when the column address strobe (C̄ĀS̄) assumes the HIGH level, characterised in that the control of the data output (DA) via the column address strobe (C̄ĀS̄) is contrived to be such that the respective data information which occurs at the data output (DA) and which is made available by the shift register (RS), following the decay of the column address strobe signal (C̄ĀS̄) which initiates its read-out, remains at the data output (DA) of the store for a further determinate time interval - which possibly continues until the start of the next column address strobe signal (C̄ĀS̄), and that the extension of the availability of the data information at the data output (DA) obtainable in this way, controlled via the row address strobe (R̄ĀS̄), is effective in a second operating mode of the semiconductor circuit in which, when the column address strobe (C̄ĀS̄) assumes the HIGH level the row address strobe (R̄ĀS̄) simultaneously assumes the LOW level.

2. A semiconductor circuit as claimed in Claim 1, characterised in that the effectiveness and ineffectiveness of the extension is achieved by an appropriate design of an output component (OLB) which includes the data output (DA) of the store.

3. A semiconductor circuit as claimed in Claim 1 or 2, characterised in that the output component (OLB) of the store, which includes the data output (DA) of the store and is supplied with mutually-inverted data signals (D,D̄), in a manner controlled by the column address strobe (C̄ĀS̄), by the intermediate registers (RG) which are coupled to the column lines of the storage matrix (SP), comprises two mutually-identical output transistors (T1, T2) and a clock-controlled output register which forwards the obtained data signals to the two output transistors (T1, T2), that here the two output transistors (T1, T2) form a series arrangement which is connected, on the one hand, to supply potential ($V_{CC}$) and, on the other hand, to reference potential, and which comprises the data output (DA) between the two transistors, where the gate of the first output transistor (T1) is directly connected to that output (Do) which supplies the non-inverted data signal, and the gate of the other output transistor (T2) is directly connected to that output (D̄ō) of the output register (OL, OL*) which supplies the inverted data signal, that moreover the two data outputs (Do, D̄ō) of the output register (OL, OL*) are each connected to the reference potential ($V_{SS}$) via a MOS discharge transistor (T3 and T4) which is controlled by a further common clock signal ($Ø_k'$, $Ø_M$), and that finally a pulse shaper which is supplied with the column address strobe (C̄ĀS̄) and the row address strobe (R̄ĀS̄) is provided for the generation of the control clock signal for the two discharge transistors (T3, T4), and a further pulse shaper which is controlled both by the column address strobe and by the row address strobe is provided for the generation of a clock signal ($Ø_o$) for the output register (OL, OL*).

4. A semiconductor circuit as claimed in Claim 3, characterised in that, in the output register, the gate of a first MOS field-effect transistor (1) and the gate of a second MOS field-effect transistor (2) are each connected to one nf the two inputs (D, D̄) of the output register (OL, OL*) which conduct the mutually-inverted data items, and the two MOS field-effect transistors (1, 2) are supplied at their drains in the same way with the clock signal ($Ø_o$) which controls the output register (OL, OL*), that moreover the source terminal of each of the two MOS field-effect transistors (1, 2) on the one hand forms one of the two data outputs (Do, D̄ō) of the output register (OL, OL*), and is connected to the drain of a further MOS field-effect transistor (3, 4), where the source terminal of these two further transistors (3, 4) is connected to reference potential ($V_{SS}$) and their gate is connected to the drain of the respective other of these two transistors (3, 4).

5. A semiconductor circuit as claimed in Claim 4, characterised in that, for the generation of the clock signal ($Ø_o$) which serves to control the output register (OL, OL*), a NOR-gate (N1) which is controlled both by the row address strobe (R̄ĀS̄) and by the column address strobe (C̄ĀS̄) acts upon the set input (S) of an RS-type flip-flop stage (FF) whose non-inverted output (Q) is connected via a delay element - formed for example by means of inverters (I1, I2) - to the input of an AND-gate (U2) which supplies the desired clock signal ($Ø_o$), whereas the other input of this AND-gate (U2) is controlled via an inverter (I3) by the column address strobe (C̄ĀS̄), and the reset (R) of the RS-type flip-flop stage (RF) is directly connected to the row address strobe (R̄ĀS̄) (Figure 3c).

6. A semiconductor circuit as claimed in Claim 4 or 5, characterised in that the data inputs (D, D̄) of the output register (OL) are each directly formed by the gate of one of the two MOS field-effect transistors (1, 2) which are supplied with the clock signal ($Ø_o$) at their drain.

7. A semiconductor circuit as claimed in Claim 4 or 5, characterised in that the data outputs (D, D̄) of the output register (OL*) are each formed by the source terminal of a further MOS field-effect transistor (5, 6), that the gate of each of these further MOS field-effect transistors (5, 6) is controlled by a common second clock signal ($Ø_C$) whilst their drain terninal is, in each case, connected to the gate of one of the two MOS field-effect transistors (1, 2) which are commonly controlled at their drain by the first clock signal ($Ø_o$), that moreover the gate of these MOS field-effect transistors (1, 2), which are controlled by the first clock signal ($Ø_o$), is connected to the reference potential ($V_{SS}$) via a parallel arrangement of two further MOS field-effect transistors (7, 9 and 5, 10), and that one MOS field-effect transistor (9 and 8) of each of these two parallel arrangements is directly connected by its gate to the source terminal of that one of the two field-effect transistors (2, 1), which are supplied with the first clock signal ($Ø_o$), whose gate is connected to the reference potential ($V_{SS}$) via the respective other parallel arrangement (8, 10 and 7, 9), whereas, for the control of the two other transistors (7, 10), a common third clock signal ($Ø_C$) is provided whose time curve is inverted with respect to that of the second clock signal ($Ø_C$).

8. A semiconductor circuit as claimed in Claim 7, characterised in that, for the generation of the second and trird clock signals ($Ø_C$, $Ø̄_C$), the row address strobe (C̄ĀS̄) is conducted across an inverter (I4), which supplies the second clock signal ($Ø_C$), and via a non-inverting amplifier (V*) which supplies the third clock signal ($Ø̄_C$) and, in particular, has the same delay as the inverter (I4).

9. A semiconductor circuit as claimed in one of Claims 3 to 8, characterised in that the system which supplies the clock pulses ($Ø_k'$) which serve to control the discharge transistors (T3, T5), and which is controlled by the column address strobe (C̄ĀS̄) and by the row address strobe (R̄ĀS̄), consists of an input section (EG) formed, for example, by a non-inverting amplifier, and a delay element (VG) which is controlled by the output of the latter, where the input section (EG) is supplied directly with the column address strobe (C̄ĀS̄).

10. A semiconductor circuit as claimed in Claim 2 and 9, characterised in that the gates of the two discharge transistors (T3, T4) are acted upon by a circuit node (K) which, on the one hand, is directly connected to the output of the input section (EG), itself controlled by the column address strobe (C̄ĀS̄), of the system which supplies the pulses (Øₖ') for the control of the discharge transistors (T3, T4) and, on the other hand, is connected to the output of the delay element (VG) in each case via a transfer transistor (T6, T5), and that the gate of the two transfer transistors (T5, T6) is controlled by two mutually-inverted pulses (Ø_R and Ø̄_R), and that these pulses (Ø_R, Ø̄_R) are produced by the row address strobe (R̄ĀS̄) by means of a pulse shaper (TG).

11. A semiconductor circuit as claimed in Claim 10, characterised in that the pulse shaper (TG) is formed on the one hand by a non-inverting amplifier (V) which is connected by its output to the gate of the transfer transistor (T6) which controls the connection between the output of the input section (EG) and the circuit node (K), and is formed on the other hand by an inverting amplifier (I3) which is connected by its output to the gate of the transfer transistor (T5) which controls the connection between the output of the delay element (VG) and the circuit node (K), and that the input of the two amplifiers (V, I3) is commonly supplied by the row address strobe (R̄ĀS̄).

12. A semiconductor circuit as claimed in Claim 11, characterised in that the inverting amplifier (I3) and the non-inverting amplifier (V) are set at the same delay time.

13. A semiconductor circuit as claimed in one of Claims 2, 3 and 7, characterised in that the output section (OLB) of the store, which includes the data output (DA), is designed to be such that, in the second operating mode of the semiconductor circuit, in spite of the disconnection of the column address strobe (C̄ĀS̄), the data output (DA) remains available at HIGH until the column address strobe (C̄ĀS̄) returns to the level LOW and thus starts a new nibble or byte mode cycle, that moreover, a tri-state phase of the data output (DA) exists at the maximum for an interval of time which is shorter than the duration of the individual active phases of the column address strobe (C̄ĀS̄), and that finally, at the end of each read cycle when both the row address strobe (R̄ĀS̄) and the column address strobe (C̄ĀS̄) assume the HIGH level, the address strobe which later terminates the active phase (i.e. reaches the level HIGH) disconnects the data output (DA).

14. A semiconductor circuit as claimed in Claim 7 and 13, characterised in that the control pulses (Ø_M) which serve to control the two discharge transistors (T3, T4), which connect the two data outputs (Do, D̄o) of the output register (OL*) to the reference potential (V_SS), are emitted from the non-inverting signal output (Q) of a flip-flop stage (FFL) whose set input is controlled by the output of an AND-gate (U3), and whose reset input (R) is controlled by the output of a NOR-gate (N2), and which are commonly controlled at their two signal inputs both by the column address strobe (C̄ĀS̄) and by the row address strobe (R̄ĀS̄).

15. A semiconductor circuit as claimed in Claim 14, characterised in that both the AND-gate (U3) and the NOR-gate (N2) are directly controlled both by the column address strobe (C̄ĀS̄) and by the row address strobe (R̄ĀS̄).

16. A semiconductor circuit as claimed in Claim 19, characterised in that the AND-gate (U3) and the NOR-gate (N2) are supplied directly with the column address strobe (C̄ĀS̄), and the NOR-gate (N2) is likewise supplied directly with the row address strobe (R̄ĀS̄), whilst the row address strobe (R̄ĀS̄) is applied to the allocated input of the AND-gate (U3) via a delay element (VZ).

17. A semiconductor circuit as claimed in Claim 7 and 13, characterised in that, for the generation of the clock puises (Ø_M) required for the control of the two discharge transistors (T3, T4), a construction of five inverter stages with a boot-strap load and an intermediate stage is provided, that the driver transistor (13) of the first boot-strap inverter stage (13, 11, 12, C1) is controlled by the row address strobe (R̄ĀS̄), and the driver transistor (16) of the second boot-strap inverter stage (15, 14, 15, C2) is controlled by the signal output (A) - controlled by the drain of the driver transistor (13) of the first boot-strap inverter stage - of this inverter stage, that moreover, the output (A) of the first inverter stage serves to control a precharging of the boot-strap load (17, 18, C3) of a third inverter stage, and the driver transistor (19) of this third inverter stage is controlled by the column address strobe (C̄ĀS̄), that moreover, the fourth boot-strap inverter stage (22, 20, 21, C3) is controlled by the output of the third boot-strap inverter stage (19, 17, 18, C3), that moreover, the intermediate stage consists of three series-connected MOS field-effect transistors (23, 24, 25) of which the first transistor (23) is connected by its drain to the supply potential (V_CC) and by its gate to the output of the third inverter stage which is controlled by the column address strobe (C̄ĀS̄), whilst its source terminal, which forms the output of the intermediate stage, on the one hand serves to control a fifth boot-strap inverter stage (29, 27, 28, C5) and, on the other hand is connected in parallel to the reference potential (V_SS) both via a further MOS field-effect transistor (26), fed-back from the output of the fifth inverter stage, and via the series arrangement of two MOS field-effect transistors (24, 25), and that finally the boot-strap inverter stages are connected by their load to the supply potential (V_CC) and by their driver transistor to the reference potential (V_SS), and that the output which supplies the clock pulses (Ø_M) reguired for the control of the discharge transistors (T3, T4) is formed by the drain of the driver transistor (29) of the last boot-strap inverter stage (29, 27, 28, C5).

18. A semiconductor circuit as claimed in one of the preceding Claims, <u>characterised in that</u> the circuit components used therein are designed in single-channel MOS-technology, in particular n-channel MOS-technology.

**Revendications**

1. Circuit à semi-conducteurs intégré avec une mémoire dynamique lecture-écriture, dans laquelle la matrice de mémoire (SP), constituée de cellules de mémoire identiques les unes aux autres, notamment de cellules de mémoire à un transistor, peut être adressée par l'intermédiaire de décodeurs de lignes et de colonnes relatifs aux cellules de mémoire individuelles et l'adressage des lignes de matrice individuelles y est déclenché par un signal de cadence d'adressage des lignes ($\bar{R}\bar{A}\bar{S}$), et l'adressage des colonnes de matrice individuelles y est déclenché par un signal de cadence d'adressage des colonnes ($\bar{C}\bar{A}\bar{S}$), dans lequel l'adressage est réalisé de manière à ce que, lors du processus de lecture, l'information d'au moins deux cellules de mémoire prévues pour la mémorisation des données est en même temps traitée et mémorisée temporairement dans un registre tampon (RG), et de plus est prévu un registre à décalage (RS) actionné exclusivement par le signal de cadence d'adressage des colonnes ($\bar{C}\bar{A}\bar{S}$) et destiné à la transmission série, des informations qui sont contenues en même temps dans la matrice de mémoire, sur la sortie des données (DA) de la mémoire, et dans lequel, dans un premier mode de fonctionnement décrit comme fonctionnement "Normal" où une mise hors circuit de la sortie des données (DA) par le signal de cadence d'adressage des colonnes ($\bar{C}\bar{A}\bar{S}$) est liée à un état de fonctionnement-HAUT du signal de cadence d'adressage des lignes ($\bar{R}\bar{A}\bar{S}$), cette mise hors circuit de la sortie des données (DA) entraîne, sans retard, la transition du signal de cadence d'adressage des colonnes ($\bar{C}\bar{A}\bar{S}$) à l'état-HAUT, caractérisé en ce que la commande de la sortie des données (DA) par l'intermédiaire du signal de cadence d'adressage des colonnes ($\bar{C}\bar{A}\bar{S}$) est réalisé d'une manière telle que l'information de données, présente chaque fois à la sortie des données (DA) et mise à disposition par le registre à décalage (RS), reste, après la disparition du signal de cadence d'adressage des colonnes ($\bar{C}\bar{A}\bar{S}$) autorisant sa lecture, maintenue sur la sortie des données (DA) de la mémoire encore un intervalle de temps défini - éventuellement allant jusqu'à l'apparition du signal de cadence d'adressage des colonnes ($\bar{C}\bar{A}\bar{S}$) suivant - et que l'allongement de la disponibilité de l'information des données sur la sortie des données (DA), pouvant être ainsi obtenue, place, par l'intermédiaire du signal de cadence d'adressage des lignes ($\bar{R}\bar{A}\bar{S}$), le circuit à semi-conducteurs dans un second mode de fonctionnement où il est actif, dans lequel, lors du passage du signal de cadence d'adressage des colonnes ($\bar{C}\bar{A}\bar{S}$) à l'état-HAUT le signal de cadence d'adressage des lignes ($\bar{R}\bar{A}\bar{S}$) se trouve en même temps au niveau-BAS.

2. Circuit à semi-conducteurs selon la revendication 1, caractérisé en ce que l'activité de l'allongement et son inactivité sont obtenus par la réalisation correspondante d'un étage de sortie (OLB) présentant la sortie des données (DA) de la mémoire.

3. Circuit à semi-conducteurs selon la revendication 1 ou 2, caractérisé en ce que l'étage de sortie (OLB) de la mémoire présentant la sortie des données (DA) de la mémoire et attaqué, par les signaux de sortie (D, $\bar{D}$) inversé l'un par rapport à l'autre, d'une manière commandée par le signal de cadence d'adressage des colonnes ($\bar{C}\bar{A}\bar{S}$), du registre tampon (RC) couplé aux conducteurs des colonnes de la matrice de mémoire (SP), comprend deux transistors de sortie (T1, T2) identiques ainsi qu'un registre de sortie commandé de manière synchronisée et transmettant les signaux de données qu'il contient aux deux transistors de sortie (T1, T2), que, à cet effet, les deux transistors de sortie (T1, T2) forment un circuit série-porté d'une part au potentiel d'alimentation ($V_{CC}$) et d'autre art au potentiel de référence et présentant entre les deux transistors la sortie des données (DA)-, la grille d'un des transistors de sortie (T1) étant directement reliée à la sortie (Do) délivrant le signal de données non inversé du registre de sortie (OL, OL*) et la grille de l'autre transistor de sortie (T2) étant directement reliée à la sortie ($\bar{D}o$) dudit registre délivrant le signal de données inversé, que de plus les deux sorties de données (Do, $\bar{D}o$) du registre de sortie (OL, OL*) sont portées, chacune par l'intermédiaire d'un transistor MOS de décharge (T3 ou T4) commandé par un autre signal de cadence commun ($\varnothing'_k$, $\varnothing_M$), au potentiel de référence ($V_{SS}$), et enfin que pour générer le signal de cadence destiné aux transistors de décharge (T3, T4), est prévu un conformateur d'impulsions attaqué par le signal de cadence d'adressage des colonnes ($\bar{C}\bar{A}\bar{S}$) ainsi que par le signal de cadence d'adressage des lignes ($\bar{R}\bar{A}\bar{S}$), et que pour générer les signaux d'impulsions ($\varnothing_o$) destinés au registre de sortie (OL, OL*), est prévu un autre conformateur d'impulsions commandé aussi bien par le signal de cadence d'adressage des colonnes que par le signal de cadence d'adressage des lignes.

4. Circuit à semi-conducteurs selon la revendication 3, caractérisé en ce que dans le registre de sortie, la grille d'un premier transistor-MOS à effet de champ (1) et la grille d'un deuxième transistor-MOS à effet de champ (2) sont chacune attaquées par une des deux entrées (D, $\bar{D}$) du registre de sortie (OL, OL*) qui applique des données inversées les unes par rapport aux autres, et les deux transistors-MOS à effet de champ (1, 2) sont attaqués sur leur drain de manière identique par le signal de cadence

($Ø_o$) commandant le registre de sortie (OL, OL*), que de plus la borne de source de chacun des deux transistors-MOS à effet de champ (1, 2) forme une des deux sorties de données (Do, $\bar{D}\bar{o}$) du registre de sortie (OL, OL*), de même qu'elle est reliée au drain d'un autre transistor-MOS à effet de champ (3, 4), la borne de source de ces deux autres transistors (3, 4) étant portée au potentiel de référence ($V_{SS}$) et leur grille respective étant reliée au drain de l'autre de ces deux transistors (3, 4).

5. Circuit à semi-conducteurs selon la revendication 4, caractérisé en ce que pour générer le signal de cadence ($Ø_o$) prévu pour commander le registre de sortie (OL, OL*), est prévue une porte NON-OU (N1) commandée aussi bien par le signal de cadence d'adressage des lignes ($\bar{R}\bar{A}\bar{S}$) que par le signal de cadence d'adressage des colonnes ($\bar{C}\bar{A}\bar{S}$) et destinée à attaquer l'entrée d'activation d'une bascule RS (FF), dont la sortie non inversée (Q) est reliée, par l'intermédiaire d'un élément de retard - par exemple réalisé au moyen d'inverseurs (I1, I2) - à l'entrée d'une porte ET (U2) délivrant les signaux de cadence désirés ($Ø_o$), alors que l'autre entrée de cette porte ET (U2) est commandée par le signal de cadence d'adressage des colonnes ($\bar{C}\bar{A}\bar{S}$) par l'intermédiaire d'un inverseur (I3) et que l'entrée de désactivation (R) de la bascule RS (FF) est directement attaquée par le signal de cadence d'adressage des lignes ($\bar{R}\bar{A}\bar{S}$) (figure 3c).

6. Circuit à semi-conducteurs selon la revendication 4 ou 5, caractérisé en ce que les entrées de données (D, $\bar{D}$) du registre de sortie (OL) sont chacune reliées directement à la grille d'un des deux transistors-MOS à effet de champ (1, 2) attaqués sur leur drain par le signal de cadence ($Ø_o$).

7. Circuit à semi-conducteurs selon la revendication 4 ou 5, caractérisé en ce que les sorties de données (D, $\bar{D}$) du registre de sortie (OL*) sont chacune reliées à la borne de source d'un autre transistor-MOS à effet de champ (5, 6), qu'à cet effet les grilles de ces autres transistors-MOS à effet de champ (5, 6) sont commandées par un deuxième signal de cadence ($Ø_C$) commun, alors que leur borne de drain est reliée à un des deux transistors-MOS à effet de champ (1, 2) attaqués ensemble sur leur drain par le premier signal de cadence ($Ø_o$), que de plus les grilles de ces transistors-MOS à effet de champ (1, 2), commandés par le premier signal de cadence ($Ø_o$), sont portées au potentiel de référence ($V_{SS}$), chacune par l'intermédiaire d'un circuit parallèle de deux autres transistors-MOS à effet de champ (7, 9 respectivement 8, 10), et que chaque fois un transistor-MOS à effet de champ (9 ou 8) de chacun de ces deux circuits parallèles est relié, par sa grille, directement à la borne de source de celui des deux transistors-MOS à effet de champ (2, 1) attaqués par le premier signal de cadence ($Ø_o$) dont la grille est portée au potentiel de référence ($V_{SS}$) par l'intermédiaire de l'autre circuit parallèle (8, 10 respectivement 7, 9), alors que pour la commande des deux autres transistors (7, 10) est prévu un troisième signal de cadence ($Ø_C$) commun, dont l'allure temporelle est inversée par rapport au deuxième signal de cadence ($Ø_C$).

6. Circuit à semi-conducteurs selon la revendication 7, caractérisé en ce que pour générer le deuxième et le troisième signal de cadence ($Ø_C$, $Ø_C$), le signal de cadence d'adressage des colonnes ($\bar{C}\bar{A}\bar{S}$) est appliqué à un inverseur (I4) délivrant le deuxième signal de cadence ($Ø_C$) à un amplificateur (V*) - qui présente notamment le même retard que l'inverseur (I4) - délivrant le troisième signal de cadence ($Ø_C$).

9. Circuit à semi-conducteurs selon une des revendications 3 à 8, caractérisé en ce que le dispositif qui délivre les impulsions servant à commander les transistors de décharge (T3, T4) et qui sont commandés par le signal de cadence d'adressage des colonnes ($\bar{C}\bar{A}\bar{S}$) ainsi que par le signal de cadence des lignes ($\bar{R}\bar{A}\bar{S}$), se compose d'un étage d'entrée (EG) - par exemple constitué d'un amplificateur non inverseur et d'un élément de retard (VG) commandé par la sortie dudit étage d'entrée, l'étage d'entrée (EG) étant directement attaqué par le signal de cadence d'adressage des colonnes ($\bar{C}\bar{A}\bar{S}$).

10. Circuit à semi-conducteurs selon la revendication 2 et 9, caractérisé en ce que pour alimenter la grille des deux transistors de décharge (T3, T4) est prévu un noeud du circuit (K) qui est alimenté, chaque fois sous l'influence d'un transistor de transfert (T6, T5), d'une part directement par la sortie de l'étage d'entrée, qui est de son côté commandé par le signal de cadence d'adressage des colonnes ($\bar{C}\bar{A}\bar{S}$), du dispositif qui délivre les impulsions ($Ø'_k$) pour la commande des transistors de décharge (T3, T4), et d'autre part par la sortie de l'étage de retard (VG), et que la grille des deux transistors de transfert (T5, T6) est commandée par des impulsions ($Ø_R$ respectivement $Ø_R$) inversées les unes par rapport aux autres et que ces impulsions ($Ø_R$, $Ø_R$) sont générées au moyen d'un conformateur d'impulsions (TG) par le signal de cadence d'adressage des lignes ($\bar{R}\bar{A}\bar{S}$).

11. Circuit à semi-conducteurs selon la revendication 10, caractérisé en ce que le conformateur d'impulsions (TG) est constitué d'une part d'un amplificateur non inverseur (V) connecté par sa sortie à la grille du transistor de transfert (T6) qui commande la liaison entre la sortie de l'étage d'entrée (EG) et le noeud du circuit (K), et d'autre part par un amplificateur inverseur (I3) connecté par sa sortie à la grille du transistor de transfert (T5) qui commande la liaison entre la sortie de l'élément de retard (VG) et le noeud du circuit (K), et que l'entrée des deux amplificateurs (V, I3) est attaquée en commun par le signal de cadence d'adressage des lignes ($\bar{R}\bar{A}\bar{S}$).

12. Circuit à semi-conducteurs selon la revendication 11, caractérisé en ce que l'amplificateur inverseur (I3) et l'amplificateur

non inverseur (V) sont ajustés sur un temps de retard identique.

13. Circuit à semi-conducteurs selon une des revendications 2, 3 et 7, caractérisé en ce que l'étage de sortie (OLB) de la mémoire, présentant la sortie des données (DA), est réalisé de telle manière que dans le second mode de fonctionnement du circuit à semi-conducteurs, la sortie des données (DA) reste en disponibilité HAUTE, même lors de l'annulation du signal de cadence d'adressage des colonnes (C̄ĀS̄), et ce jusqu'à ce que le signal de cadence d'adressage des colonnes (C̄ĀS̄) revienne au niveau BAS et ainsi démarre un nouveau cycle en "mode-fragment" ou en "mode-multiplet", que de plus une phase tri-état de la sortie des données (DA) est fournie pour un intervalle de temps plus court par rapport à la durée des phases actives individuelles du signal de cadence d'adressage des colonnes (C̄ĀS̄), et enfin qu'à la fin de chaque cycle de lecture quand aussi bien le signal de cadence d'adressage des lignes (R̄ĀS̄) que le signal de cadence d'adressage des colonnes (C̄ĀS̄) sont à l'état HAUT, le signal de cadence d'adressage terminant le plus tard la phase active, c.à.d. atteignant le niveau HAUT, met hors circuit la sortie des données (DA).

14. Circuit à semi-conducteurs selon la revendication 7 et 13, caractérisé en ce que les impulsions de commande (Ø$_M$), prévues pour commander les deux transistors de décharge (T3, T4) qui portent les deux sorties de données (Do, D̄ō) du registre de sortie (OL*) au potentiel de référence (V$_{SS}$), sont délivrées par la sortie des signaux non inversés (Q) d'un multivibrateur bistale (FFL), dont l'entrée d'activation (S) est commandée par la sortie d'une porte ET (U3) et dont l'entrée de désactivation (R) est commandée par la sortie d'une porte NON-OU (N2), et lesdites portes sont commandées ensemble sur leurs deux entrées de signaux aussi bien par le signal de cadence d'adressage des colonnes (C̄ĀS̄) que par le signal de cadence d'adressage des lignes (R̄ĀS̄).

15. Circuit à semi-conducteurs selon la revendication 14, caractérisé en ce que aussi bien la porte ET (U3) que la porte NON-OU (N2) sont commandées directement aussi bien par le signal de cadence d'adressage des colonnes (C̄ĀS̄) que par le signal de cadence d'adressage des lignes (R̄ĀS̄).

16. Circuit à semi-conducteurs selon la revendication 14, caractérisé en ce que l'alimentation de la porte ET (U3) et de la porte NON-OU (N2) s'effectue directement par le signal de cadence d'adressage des colonnes (C̄ĀS̄) et que l'alimentation de la porte NON-OU (N2) s'effectue également directement par le signal de cadence d'adressage des lignes (R̄ĀS̄), alors que le signal de cadence d'adressage des lignes (R̄ĀS̄) est appliqué à l'entrée de la porte ET (U3) qu'il alimente, par l'intermédiaire d'un étage de retard (VZ).

17. Circuit à semi-conducteurs selon la revendication 7 et 13, caractérisé en ce que pour générer les impulsions de cadence (Ø$_M$) nécessaires à la commande des deux transistors de décharge (T3, T4), est prévu un agencement de 5 étages inverseurs à charge de contre-réaction et d'un étage intermédiaire, qu'à cet effet le transistor d'attaque (13) du premier étage inverseur à contre-réaction (13, 11, 12, C1) est commandé par le signal de cadence d'adressage des lignes (R̄ĀS̄), et le transistor d'attaque (16) du deuxième étage inverseur à contre-réaction (16, 14, 15, C2) est commandé par la sortie des signaux (A) de cet étage inverseur formée par le drain du transistor d'attaque (13) du premier étage inverseur à contre-réaction, que de plus le premier étage inverseur est prévu pour commander avec sa sortie (A) une charge de la charge à contre-réaction (17, 18, C3) d'un troisième étage inverseur et le transistor d'attaque (19) de ce troisième étage inverseur est commandé par le signal de cadence d'adressage des colonnes (C̄ĀS̄), que de plus le quatrième étage inverseur à contre-réaction (22, 20, 21, C4) est commandé par la sortie du troisième étage inverseur à contre-réaction (19, 17, 18, C3), qu'en outre l'étage intermédiaire se compose de trois transistors-MOS à effet de champ (23, 24, 25), parmi lesquels les une derrière les autres le premier transistor (23) est porté par son drain au potentiel d'alimentation (V$_{CC}$) et est relié par sa grille à la sortie du troisième étage inverseur commandé par le signal d'impulsions d'adressage des colonnes (C̄ĀS̄), alors que sa borne de source qui constitue la sortie de l'étage intermédiaire est d'une part prévue pour commander un cinquième étage inverseur à contre-réaction (29, 27, 28, C5) et est d'autre part, suivant un arrangement en parallèle, porté au potentiel de référence (V$_{SS}$) aussi bien par l'intermédiaire d'un autre transistor-MOS à effet de champ (26) commandé en retour par la sortie du cinquième étage inverseur que par l'intermédiaire du circuit série de deux transistors-MOS à effet de champ (24, 25), et enfin que les étages inverseurs à contre-réaction sont portés par leur charge au potentiel d'alimentation (V$_{SS}$) ainsi que par leur transistor d'attaque au potentiel de référence (V$_{SS}$), et la sortie, délivrant les impulsions de cadence (Ø$_M$) nécessaires à la commande des transistors de décharge (T3, T4), est fournie par le drain du transistor d'attaque (29) du dernier étage inverseur à contre-réaction (29, 27, 28, C5).

18. Circuit à semi-conducteurs selon une des revendications précédentes, caractérisé en ce que les parties du circuit utilisant la technologie MOS à un canal sont notamment réalisées suivant la technologie MOS à canal N.

# FIG 1

g = gültig

# FIG 2

0 111 741

## FIG 3

## FIG 3a

3

# FIG 3b

# FIG 3c

# FIG 4

# FIG 4a

# FIG 4b

# FIG 4c

# FIG 4d

# FIG 5

# FIG 5a

# FIG 5b

# FIG 5c

# FIG 5d

# FIG 5e